# EUROPÄISCHE PATENTSCHRIFT

(11) **EP 2 430 890 B1**
(45) Veröffentlichungstag und Bekanntmachung des Hinweises auf die Patenterteilung: **10.12.2014**
(21) Anmeldenummer: 10721985.9
(22) Anmeldetag: 12.05.2010
(51) Int. Cl.: H05K 3/00, C25D 7/06, C25D 17/00, C25D 21/10

(54) **VERFAHREN UND ANLAGE ZUM BEHANDELN VON FLÄCHIGEM BEHANDLUNGSGUT UND VORRICHTUNG ZUM ENTFERNEN ODER ABHALTEN VON BEHANDLUNGSFLÜSSIGKEIT**
METHOD AND SYSTEM FOR THE TREATMENT OF FLAT FEEDSTOCK, AND DEVICE FOR REMOVING OR KEEPING AWAY TREATMENT LIQUID
PROCÉDÉ ET DISPOSITIF DE TRAITEMENT DE PRODUITS À TRAITER PLATS ET DISPOSITIF D'ENLÈVEMENT OU DE RETENUE DE LIQUIDE DE TRAITEMENT

(30) Priorität: 13.05.2009 DE 102009021042
(43) Veröffentlichungstag der Anmeldung: 21.03.2012
(73) Patentinhaber: Atotech Deutschland GmbH, 10553 Berlin (DE)
(72) Erfinder: KUNZE, Henry, 90530 Wendelstein (DE); WIENER, Ferdinand, 90559 Burgthann (DE)
(74) Vertreter: Meier, Florian
(86) Internationale Anmeldenummer: PCT/EP2010/002939
(87) Internationale Veröffentlichungsnummer: WO 2010/130445

(56) Entgegenhaltungen:
- DE-A1- 19 519 211
- DE-B3- 10 358 149
- DE-C1- 10 206 660

## Beschreibung

Die Erfindung betrifft ein Verfahren und eine Anlage zum Behandeln von flächigem Behandlungsgut und eine Vorrichtung zum Entfernen oder Abhalten von Behandlungsflüssigkeit von einem flächigen Behandlungsgut. Insbesondere betrifft die Erfindung derartige Verfahren, Anlagen und Vorrichtungen, die eine Behandlung von Behandlungsgut mit einer empfindlichen Oberfläche oder mehreren empfindlichen Oberflächen erlauben. Die Erfindung betrifft auch derartige Verfahren, Anlagen und Vorrichtungen, bei denen eine Berührung zwischen einem zu behandelnden Nutzbereich des Behandlungsgutes und festen Elementen weitgehend vermieden werden kann, wenn Flüssigkeit von dem Behandlungsgut entfernt wird.

Bei der Bearbeitung von flächigem Behandlungsgut, wie beispielsweise Leiterplatten in der Leiterplattenindustrie, findet eine Behandlung des Behandlungsgutes häufig in einer nasschemischen Prozesslinie statt. Um Behandlungsflüssigkeit, wie eine Prozesschemikalie oder Wasser, zu entfernen, können so genannte Abquetschwalzen verwendet werden. Derartige Walzen können beispielsweise eingesetzt werden, um ein Anstauen von Behandlungsflüssigkeit für eine Tauchbehandlung in einer Behandlungsstation vorzunehmen, wie dies in der DE 43 37 988 A1 beschrieben ist.

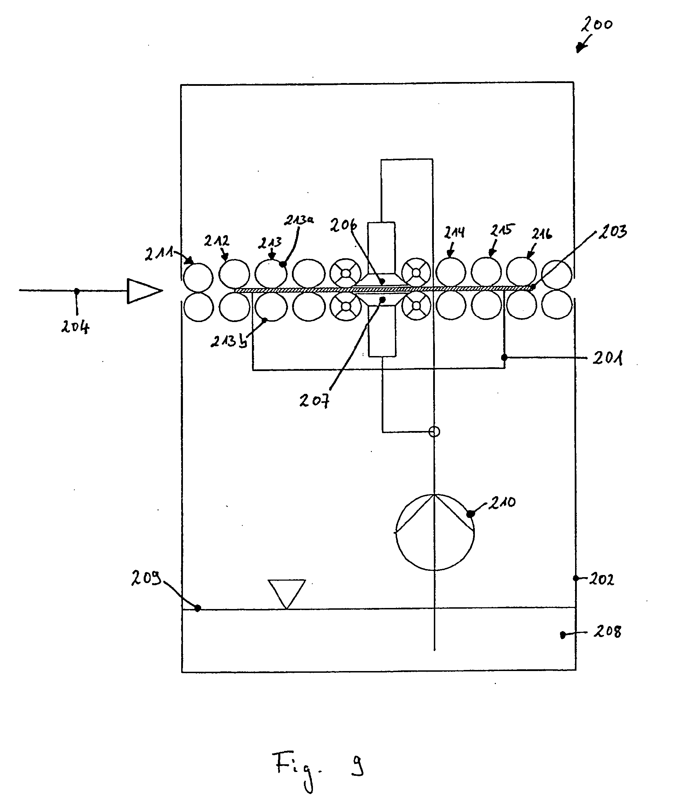

Fig. 9 ist eine schematische Darstellung einer Behandlungsstation 200, in der das Flüssigkeitsniveau der Behandlungsflüssigkeit höher als eine Transportebene des Behandlungsgutes 203 ist, so dass das Behandlungsgut 203 eingetaucht transportiert werden kann. Das Behandlungsgut 203 wird in einer horizontalen Transportrichtung 204 durch die Behandlungsstation transportiert. Zum Transportieren des Behandlungsgutes sind Walzenpaare 211-216 vorgesehen, die in Anlage mit den nach oben bzw. unten zeigenden Oberflächen des Behandlungsgutes 203 kommen, um dieses zu transportieren. Um das Auslaufen der Behandlungsflüssigkeit zu vermeiden, ist ein Innenbehälter 201 vorgesehen, in dem die Behandlungsflüssigkeit auf das (nicht dargestellte) hohe Niveau angestaut ist. Der Innenbehälter 201 wird von einem Außenbehälter 202 so umfangen, dass der Außenbehälter 202 die aus dem Innenbehälter 201 überströmende Behandlungsflüssigkeit auffängt. Von der im Außenbehälter 202 aufgefangenen Behandlungsflüssigkeit 208, die im Außenbehälter ein Niveau 209 aufweist, wird die Behandlungsflüssigkeit mit einer Pumpe 210 zurück in den Innenbehälter 201 gepumpt. Die Behandlungsflüssigkeit kann über Anströmdüsen 206, 207 oder dergleichen zurück in den Innenbehälter 201 abgegeben werden.

Zum Anstauen der Behandlungsflüssigkeit in dem Innenbehälter 201 werden Paare von so genannten Abquetschwalzen 213, 215 im Ein- und Auslaufbereich des Innenbehälters 201 verwendet. Die Paare von Abquetschwalzen 213, 215 können beispielsweise eine zylinderförmige Mantelfläche aufweisen. Wenn die Abquetschwalzen 213a, 213b des Paares 213 und die Abquetschwalzen des Walzenpaares 215 an dem Behandlungsgut 203 anliegen, wird der freie Querschnitt, durch welchen die Behandlungsflüssigkeit aus dem Innenbehälter 201 austreten kann, eingeschränkt. Durch entsprechende Einstellung der Förderleistung der Pumpe 210 kann ein gewünschtes Niveau der Behandlungsflüssigkeit im Innenbehälter 201 eingestellt werden. Zusätzliche Walzenpaare, wie die Walzenpaare 211, 212, 214 und 216 im Ein- oder Auslaufbereich des Behandlungsstation können ebenfalls als Abquetschwalzen wirken.

Falls das Behandlungsgut 203 eine oder mehrere empfindliche Oberflächen aufweist, kann jedoch der direkte Kontakt zwischen den Abquetschwalzenpaaren 213, 215 und dem Behandlungsgut 203, der bei herkömmlichen Abquetschwalzen über die gesamte Breite, d.h. die gesamte Ausdehnung quer zur Transportrichtung 204, des Behandlungsgutes 203 besteht, zu Schäden an der Oberfläche des Behandlungsgutes 203 führen. Schäden an den Oberflächen des Behandlungsgutes 203 können beispielsweise durch die Flächenpressung oder an den Oberflächen der Abquetschwalzen 213, 215 anhaftende Partikel und Oberflächenunebenheiten hervorgerufen werden.

Die DE 195 19 211 A1, die als Basis für den Oberbegriff der unabhängigen Ansprüche dient, beschreibt eine Vorrichtung, die Abquetschwalzen aufweist. Darüber hinaus sind bei der Vorrichtung dieser Druckschrift weitere Walzen so angeordnet, dass sehr enge Spalten zwischen einer Leiterplatte und der Walze verbleiben, um eine hohe Strömungsgeschwindigkeit zu erzeugen.

Die DE 103 58 149 B2 beschreibt eine Vorrichtung mit Transportwalzen, wobei die Vorrichtung weiterhin Elektrolyt-Sprührohre umfasst.

Die DE 102 06 660 C1 beschreibt eine Vorrichtung mit Walzen, die die Funktion einer Abdichtung eines nasschemischen Bades übernehmen können. Die Walzen weisen Zwischenräume zwischen Aufwölbungen auf, wobei die Aufwölbungen die Leiterplatte berühren.

Der Erfindung liegt die Aufgabe zugrunde, ein Verfahren und eine Anlage zum Behandeln von flächigem Behandlungsgut und eine Vorrichtung zum Entfernen oder Abhalten von Behandlungsflüssigkeit für eine Anlage zum Behandeln von flächigem Behandlungsgut anzugeben, bei dem bzw. bei der die Gefahr einer Beschädigung empfindlicher Oberflächen des Behandlungsgutes verringert werden kann. Der Erfindung liegt auch die Aufgabe zugrunde, ein Verfahren zur Herstellung von Leiterplatten anzugeben, bei dem die Gefahr einer Beschädigung empfindlicher Oberflächenbereiche der Leiterplatte verringert werden kann.

Erfindungsgemäß wird die Aufgabe gelöst durch ein Verfahren und eine Anlage zum Behandeln von flächigem Behandlungsgut und eine Vorrichtung zum Entfernen oder Abhalten von Behandlungsflüssigkeit, wie sie in den unabhängigen Ansprüchen angegeben sind. Die abhängigen Ansprüche definieren bevorzugte und vorteilhafte Ausführungsformen der Erfindung.

Das Verfahren zum Behandeln eines flächigen Behandlungsgutes, das in einer Anlage zur nasschemischen Behandlung des Behandlungsgutes entlang einem Transportweg transportiert wird, sieht vor, dass eine Rückhaltefläche zum Zurückhalten einer Behandlungsflüssigkeit, der das Behandlungsgut in der Anlage ausgesetzt wird, vorgesehen wird. Die Rückhaltefläche wird derart an dem Transportweg positioniert, dass zwischen der Rückhaltefläche und einer Oberfläche des Behandlungsgutes ein Spalt freibleibt, wenn das Behandlungsgut an der Rückhaltefläche vorbeigeführt wird.

Als Rückhaltefläche zum Zurückhalten von Behandlungsflüssigkeit wird eine Fläche bezeichnet, die aufgrund ihrer Ausgestaltung und Anordnung ein Strömen von Flüssigkeit in wenigstens einer Richtung, insbesondere in einer Transportrichtung des Behandlungsgutes, einschränken kann. Die Rückhaltefläche muss den Flüssigkeitsstrom nicht vollständig unterbinden, sondern kann, insbesondere durch den ausgebildeten Spalt, einen Durchtritt von Behandlungsflüssigkeit erlauben.

Da die Rückhaltefläche so positioniert wird, dass zwischen der Rückhaltefläche und einer Oberfläche des Behandlungsgutes ein Spalt freibleibt, wenn das Behandlungsgut an der Rückhaltefläche vorbeigeführt wird, wird der Abschnitt des Behandlungsgutes, an dem der Spalt angeordnet ist, nicht von der Rückhaltefläche berührt. Die Rückhaltefläche kann insbesondere so ausgestaltet sein, dass sich der Spalt entlang einem Nutzbereich des Behandlungsgutes erstreckt, so dass die Rückhaltefläche den Nutzbereich des Behandlungsgutes nicht berührt.

Die Rückhaltefläche kann so ausgestaltet und angeordnet sein, dass die Rückhaltefläche einen Nutzbereich des Behandlungsgutes, der sich kontinuierlich zwischen gegenüberliegenden Randbereichen des Behandlungsgutes erstreckt, nicht berührt. Die Rückhaltefläche kann so ausgestaltet und angeordnet sein, dass die Rückhaltefläche von dem gesamten Nutzbereich des Behandlungsgutes beabstandet ist. Die Rückhaltefläche kann so ausgestaltet und angeordnet sein, dass sich der Spalt in einer Richtung quer zu der Transportrichtung des Behandlungsgutes kontinuierlich über den gesamten Nutzbereich des Behandlungsgutes erstreckt, wenn das Behandlungsgut an der Rückhaltefläche vorbeigeführt wird.

Der Spalt kann eine minimale Spalthöhe aufweisen. Als minimale Spalthöhe wird der minimale Abstand zwischen der Rückhaltefläche und dem an der Rückhaltefläche vorbeigeführten Behandlungsgut bezeichnet. Wenigstens an einer Seite der Rückhaltefläche kann die Behandlungsflüssigkeit bis zu einem Niveau angestaut werden, das höher als die minimale Spalthöhe des Spaltes ist. Das Behandlungsgut kann so an der zumindest einen Seite der Rückhaltefläche eingetaucht in die Behandlungsflüssigkeit transportiert werden. Die Rückhaltefläche kann das Flüssigkeitsniveau an dem Behandlungsgut verringern bzw. Behandlungsflüssigkeit von dem Behandlungsgut entfernen, wenn beispielsweise das Behandlungsgut an einem Auslaufbereich einer Behandlungsstation an der Rückhaltefläche vorbeigeführt wird.

Die minimale Spalthöhe kann kleiner als 1 mm, insbesondere kleiner als 0,7 mm, insbesondere kleiner als 0,5 mm sein. Die minimale Spalthöhe kann mindestens 0,05 mm, insbesondere mindestens 0,07 mm, insbesondere mindestens 0,09 mm betragen.

Eine durch den Spalt tretende Behandlungsflüssigkeit kann von dem Behandlungsgut mit einem Fluidstrom entfernt werden, beispielsweise mit einem Gasstrom abgeblasen werden. Durch die Kombination von spaltbildender Rückhaltefläche und Abblasen von Behandlungsflüssigkeit kann eine Entfernung von Behandlungsflüssigkeit erreicht werden, auch wenn Behandlungsflüssigkeit durch den Spalt tritt.

Es kann eine zweite Rückhaltefläche vorgesehen sein, die von der Rückhaltefläche beabstandet ist, um durch den Spalt tretende Behandlungsflüssigkeit von dem Behandlungsgut zu entfernen. So kann in einem Einlaufbereich einer Behandlungsstation oder in einem Auslaufbereich einer Behandlungsstation zwischen der Rückhaltefläche und der zweiten Rückhaltefläche die Behandlungsflüssigkeit bis zu einem Niveau angestaut werden, das niedriger als das Niveau der Behandlungsflüssigkeit in einem Arbeitsbereich der Behandlungsstation ist. Auf diese Weise kann eine Niveaukaskade realisiert werden.

Zum Entfernen der Behandlungsflüssigkeit mit einem Fluidstrom kann der Fluidstrom auf das Behandlungsgut gerichtet sein. Dieser kann so eingerichtet sein, dass er nicht durch den Spalt tritt. Dazu kann einer oder eine oder mehrere von einem Volumenstrom, einer Strömungsgeschwindigkeit und einer Strömungsrichtung des Fluidstroms so eingestellt werden, dass der Fluidstrom nicht durch den Spalt tritt, also beispielsweise nicht in die angestaute Behandlungsflüssigkeit tritt.

Der zum Entfernen von Behandlungsflüssigkeit verwendete Fluidstrom kann das Behandlungsgut in einer Richtung anströmen, die eine quer zu der Transportrichtung und parallel zur Transportebene des Behandlungsgutes gerichtete Komponente aufweist. So kann die Behandlungsflüssigkeit quer zur Transportrichtung von dem Behandlungsgut entfernt werden.

Die Rückhaltefläche ist an einer Walze ausgebildet. Die Walze kann sich in Breitenrichtung, d.h. quer zu der Transportrichtung des Behandlungsgutes, entlang dem Behandlungsgut erstrecken. Die Walze kann so angeordnet sein, dass sich ihre Achse parallel zur Transportebene erstreckt. Falls das Behandlungsgut in einer horizontalen Transportebene transportiert wird, kann die Walze oberhalb oder unterhalb der Transportebene vorgesehen sein. Die Walze kann so ausgebildet sein, dass die Walzenoberfläche von dem gesamten Nutzbereich des Behandlungsgutes beabstandet ist.

Die Walze wird so in Drehung versetzt, dass sich der Teil der Walzenoberfläche, der den Spalt an einer Seite begrenzt, in einer Richtung bewegt, die entgegengesetzt zu der Transportrichtung des Behandlungsgutes ist. Auf diese Weise kann beispielsweise in einem Auslaufbereich einer Behandlungsstation der Austritt von Behandlungsflüssigkeit weiter reduziert werden. Es kann auch der Stoffaustausch an der Oberfläche des Behandlungsgutes verbessert werden.

Mit der Walze kann nicht nur die Behandlungsflüssigkeit zurückgehalten oder angestaut werden, sondern auch das Behandlungsgut in der Transportrichtung transportiert werden. An der Walze kann wenigstens ein Transportabschnitt vorgesehen sein, der mit dem Behandlungsgut gekoppelt wird, um das Behandlungsgut zu transportieren. Die Rückhaltefläche kann relativ zu dem Transportabschnitt abgesetzt vorgesehen sein, um den Spalt auszubilden.

Der Transportabschnitt kann zum Transportieren des Behandlungsgutes gedreht werden. Bei einem Ausführungsbeispiel kann der Transportabschnitt relativ zu der Rückhaltefläche drehbar sein, um eine unabhängige Drehung von Transportabschnitt und Rückhaltefläche zu erlauben.

An in Transportrichtung des Behandlungsgutes entgegengesetzten Seiten des Spaltes kann ein Niveauunterschied der Behandlungsflüssigkeit eingestellt werden. An beiden Seiten des Spaltes kann Behandlungsflüssigkeit an dem Behandlungsgut vorhanden sein. Beispielsweise kann in einem Einlaufbereich oder in einem Auslaufbereich einer Behandlungsstation für das Behandlungsgut das Niveau der Behandlungsflüssigkeit stufenartig an der Rückhaltefläche geändert werden, um ein gewünschtes Flüssigkeitsniveau im Behandlungsbereich zu erzielen.

Die Rückhaltefläche kann gedreht werden, um einen Durchtritt von Behandlungsflüssigkeit durch den Spalt zu verringern oder zu unterbinden. Dazu kann die Rückhaltefläche so ausgestaltet sein und die Drehgeschwindigkeit der Rückhaltefläche so gewählt werden, dass die Verdrängung von Behandlungsflüssigkeit durch die sich drehenden Rückhaltefläche den Strom der Behandlungsflüssigkeit durch den Spalt verringert oder unterbindet.

Die Behandlungsflüssigkeit kann mit der Rückhaltefläche in einer Behandlungsstation so angestaut werden, dass das Behandlungsgut in der Behandlungsstation in die Behandlungsflüssigkeit eingetaucht transportiert wird. Das eingetauchte Transportieren des Behandlungsgutes kann insbesondere zur Behandlung von dünnem Behandlungsgut mit geringer Eigensteifigkeit eingesetzt werden.

Das Behandlungsgut kann ein folienartiges Material, insbesondere eine folienartige Leiterplatte oder Leiterfolie, sein. Das Behandlungsgut kann auch ein Endlosmaterial sein.

Die nach einem Aspekt der Erfindung vorgesehene Vorrichtung zum Entfernen oder Abhalten von Behandlungsflüssigkeit von einem flächigen Behandlungsgut für eine Anlage zur nasschemischen Behandlung des Behandlungsgutes umfasst eine Rückhaltefläche zum Zurückhalten der Behandlungsflüssigkeit. Die Vorrichtung ist eingerichtet, um relativ zu einem Transportweg des Behandlungsgutes so angeordnet zu werden, dass die Vorrichtung einen Spalt zwischen der Rückhaltefläche und einer Oberfläche des entlang dem Transportweg transportierten Behandlungsgutes ausbildet.

Die Begriffe Entfernen oder Abhalten von Behandlungsflüssigkeit werden dabei in dem Sinne verwendet, dass die Vorrichtung eingerichtet ist, um Behandlungsflüssigkeit zumindest teilweise zurückzuhalten, ohne dass die Behandlungsflüssigkeit vollständig entfernt oder abgehalten werden muss.

Da die Vorrichtung eingerichtet ist, um so positioniert zu werden, dass zwischen der Rückhaltefläche und einer Oberfläche des Behandlungsgutes ein Spalt freibleibt, wird der Abschnitt der Behandlungsgutes, an dem der Spalt ausgebildet ist, nicht von der Rückhaltefläche berührt. Die Vorrichtung kann insbesondere so ausgestaltet sein, dass sich der Spalt entlang einem Nutzbereich des Behandlungsgutes erstreckt, so dass die Rückhaltefläche den Nutzbereich des Behandlungsgutes nicht berührt.

Der Spalt kann eine minimale Spalthöhe aufweisen. Als "minimale Spalthöhe" wird der minimale Abstand zwischen der Rückhaltefläche und dem an der Rückhaltefläche vorbeigeführten Behandlungsgut bezeichnet. Die Vorrichtung kann so eingerichtet sein, dass an wenigstens einer Seite der Rückhaltefläche die Behandlungsflüssigkeit bis zu einem Niveau angestaut werden kann, das höher als die minimale Spalthöhe des Spaltes ist. Das Behandlungsgut kann so an der Seite der Rückhaltefläche eingetaucht in die Behandlungsflüssigkeit transportiert werden.

Die minimale Spalthöhe kann kleiner als 1 mm, insbesondere kleiner als 0,7 mm, insbesondere kleiner als 0,5 mm sein. Die minimale Spalthöhe kann mindestens 0,05 mm, insbesondere mindestens 0,07 mm, insbesondere mindestens 0,09 mm betragen.

Die Vorrichtung kann eine von der Rückhaltefläche beabstandete Anströmeinrichtung umfassen, die eingerichtet ist, um mit einem Fluidstrom das Behandlungsgut anzuströmen, um die Behandlungsflüssigkeit von dem Behandlungsgut zu entfernen. Mit der Anströmeinrichtung kann durch den Spalt austretende Behandlungsflüssigkeit entfernt werden.

Die Anströmeinrichtung kann eingerichtet sein, um den Fluidstrom mit einer Geschwindigkeitskomponente zu erzeugen, die parallel zur Transportebene und quer zur Transportrichtung des Behandlungsgutes gerichtet ist. Mit einer derart ausgestalteten Anströmeinrichtung kann die Behandlungsflüssigkeit quer zu der Transportrichtung von dem Behandlungsgut entfernt werden.

Die Anströmeinrichtung kann derart eingerichtet und angeordnet sein, dass der Fluidstrom nicht durch den Spalt hindurchtritt. Dazu kann einer bzw. eine oder mehrere von einem Volumenstrom, einer Strömungsgeschwindigkeit und einer Strömungsrichtung des Fluidstroms geeignet so eingerichtet sein, dass der Fluidstrom nicht durch den Spalt in die angestaute Behandlungsflüssigkeit tritt. Auf diese Weise kann eine Blasenbildung, beispielsweise in der angestauten Behandlungsflüssigkeit, durch den Fluidstrom verringert oder unterbunden werden.

Die Vorrichtung kann eine weitere Rückhaltefläche umfassen, wobei die Vorrichtung eingerichtet ist, um relativ zu dem Transportweg des Behandlungsgutes so angeordnet zu werden, dass die Vorrichtung einen weiteren Spalt zwischen der weiteren Rückhaltefläche und einer weiteren Oberfläche des entlang dem Transportweg transportierten Behandlungsgutes ausbildet. Die Rückhaltefläche und die weitere Rückhaltefläche können beispielsweise entgegengesetzten Oberflächen des Behandlungsgutes gegenüberliegen, um Flüssigkeit von diesen zu entfernen. Die Rückhaltefläche und die weitere Rückhaltefläche können an Walzen eines Walzenpaares vorgesehen sein, zwischen denen das Behandlungsgut transportiert wird.

Die Vorrichtung kann so eingerichtet sein, dass die Behandlungsflüssigkeit durch den Spalt hindurchtreten kann. Wenn der Durchtritt eines, insbesondere kleinen, Stromes von Behandlungsflüssigkeit durch den Spalt toleriert wird, kann auf Maßnahmen zur vollständigen Unterdrückung eines Durchtritts von Behandlungsflüssigkeit verzichtet werden.

Die Rückhaltefläche kann an einer drehbar gelagerten Walze der Vorrichtung ausgebildet sein. Die Walze kann so ausgebildet sein, dass die Walzenoberfläche von dem gesamten Nutzbereich des Behandlungsgutes beabstandet ist.

Die Vorrichtung kann eine Antriebseinrichtung umfassen, die eingerichtet ist, um die Walze so in Drehung zu versetzen, dass sich der Teil der Walzenoberfläche, der den Spalt an einer Seite begrenzt, in einer Richtung bewegt, die entgegengesetzt zu der Transportrichtung des Behandlungsgutes ist. Auf diese Weise kann beispielsweise in einem Auslaufbereich einer Behandlungsstation der Austritt von Behandlungsflüssigkeit weiter reduziert werden. Es kann auch der Stoffaustausch an der Oberfläche des Behandlungsgutes verbessert werden.

Die Walze kann so eingerichtet sein, dass sie nicht nur zum Zurückhalten der Behandlungsflüssigkeit mit der Rückhaltefläche, sondern auch zum Transportieren des Behandlungsgutes verwendbar ist. Dazu kann an der Walze wenigstens ein Transportabschnitt vorgesehen sein, der zum Transportieren des Behandlungsgutes mit dem Behandlungsgut koppelbar ist. An der Walze können zwei Transportabschnitte zum Transportieren des Behandlungsgutes vorgesehen sein, und die Rückhaltefläche kann zwischen den wenigstens zwei Transportabschnitten angeordnet sein. Beispielsweise können an axialen Randabschnitten der Walze Transportabschnitte vorgesehen sein, und die Rückhaltefläche kann sich zwischen den axialen Randabschnitten erstrecken. Die Rückhaltefläche kann als relativ zu dem wenigstens einen Transportabschnitt bzw. den wenigstens zwei Transportabschnitten abgesetzte Fläche ausgebildet sein.

Die Walze kann eingerichtet sein, um sich in Breitenrichtung, d.h. quer zu der Transportrichtung des Behandlungsgutes, entlang dem Behandlungsgut zu erstrecken. Falls das Behandlungsgut in einer horizontalen Transportebene transportiert wird, kann die Walze eingerichtet sein, um oberhalb oder unterhalb der Transportebene vorgesehen zu werden.

Die Vorrichtung kann so ausgebildet sein, dass die Walze senkrecht zu einer Transportebene des Behandlungsgutes verstellbar ist, beispielsweise durch Vorsehen eines vertikal verstellbaren Lagers. Bei einer so ausgebildeten Vorrichtung kann die Geometrie des Spaltes, insbesondere die minimale Spalthöhe, einstellbar sein.

Der wenigstens eine Transportabschnitt bzw. die wenigstens zwei Transportabschnitte kann bzw. können relativ zu der Rückhaltefläche drehbar sein. Die Vorrichtung kann für einen Drehantrieb des Transportabschnitts bzw. der Transportabschnitte und einen davon unabhängigen Drehantrieb der Rückhaltefläche eingerichtet sein.

Bei einer anderen Ausgestaltung kann die Vorrichtung einen quaderförmiges Element umfassen, an dem die Rückhaltefläche ausgebildet ist.

Die Vorrichtung kann für eine Verwendung bei dem Verfahren zum Behandeln des Behandlungsgutes nach einem Aspekt oder Ausführungsbeispiel eingerichtet sein.

Die nach einem Aspekt der Erfindung vorgesehene Anlage zum Behandeln eines flächigen Behandlungsgutes umfasst eine Vorrichtung zum Entfernen oder Abhalten von Behandlungsflüssigkeit von dem Behandlungsgut, die als Vorrichtung nach einem Aspekt oder Ausführungsbeispiel der Erfindung ausgestaltet ist.

Die Anlage kann mehrere derartige Vorrichtungen umfassen. Beispielsweise können mindestens zwei voneinander in einer Transportrichtung des Behandlungsgutes beabstandete Vorrichtungen vorgesehen sein, um die Behandlungsflüssigkeit von dem Behandlungsgut zu entfernen. Durch Verwendung mehrerer derartiger Vorrichtungen zum Entfernen der Behandlungsflüssigkeit ist eine weitgehende Entfernung von Behandlungsflüssigkeit möglich, auch wenn Flüssigkeit durch die von den Vorrichtungen ausgebildeten Spalte durchtritt. Alternativ oder zusätzlich können mehrere voneinander in der Transportrichtung des Behandlungsgutes beabstandete Vorrichtungen auch in einem Einlaufbereich einer Behandlungsstation vorgesehen sein, um die Behandlungsflüssigkeit in der Behandlungsstation anzustauen und einen Austritt der Behandlungsflüssigkeit aus der Behandlungsstation zu verringern.

Die Anlage kann eine Behandlungsstation umfassen, in der die Behandlungsflüssigkeit anstaubar ist. Sowohl in einem Einlaufbereich der Behandlungsstation als auch in einem Auslaufbereich der Behandlungsstation kann jeweils eine Vorrichtung zum Entfernen oder Abhalten von Behandlungsflüssigkeit von dem Behandlungsgut vorgesehen sein. Mit den Vorrichtungen kann die Behandlungsflüssigkeit in der Behandlungsstation angestaut werden. In dem Einlaufbereich und/oder in dem Auslaufbereich können auch jeweils mindestens zwei Vorrichtungen zum Entfernen oder Abhalten von Behandlungsflüssigkeit vorgesehen sein. Mit den mindestens zwei Vorrichtungen kann die Behandlungsflüssigkeit in mehreren Niveaustufen angestaut werden.

Die Anlage kann eingerichtet sein, um die Rückhaltefläche einer in dem Einlaufbereich der Behandlungsstation oberhalb der Transportebene vorgesehenen Vorrichtung und die Rückhaltefläche einer in dem Auslaufbereich der Behandlungsstation oberhalb der Transportebene vorgesehenen Vorrichtung gegensinnig zu drehen. Zusätzlich oder alternativ kann die Anlage eingerichtet sein, um die Rückhaltefläche einer in dem Einlaufbereich der Behandlungsstation unterhalb der Transportebene vorgesehenen Vorrichtung und die Rückhaltefläche einer in dem Auslaufbereich der Behandlungsstation unterhalb der Transportebene vorgesehenen Vorrichtung gegensinnig zu drehen. Durch geeignete Wahl der Drehrichtungen kann der Durchtritt von Behandlungsflüssigkeit durch die Spalte der in dem Einlaufbereich und dem Auslaufbereich vorgesehenen Vorrichtungen verringert oder unterbunden werden.

Nach einem weiteren Aspekt wird ein Verfahren zum Herstellen einer Leiterplatte angegeben. Dabei ist vorgesehen, die Leiterplatte aus einem Behandlungsgut herzustellen, das mit dem Verfahren zum Behandeln des Behandlungsgutes nach einem Aspekt oder Ausführungsbeispiel behandelt wurde. Mit dem Verfahren kann beispielsweise eine gedruckte Leiterplatte hergestellt werden.

Ausführungsbeispiele der Erfindung erlauben es, in einer Anlage zur nasschemischen Behandlung eines Behandlungsgutes eine Behandlungsflüssigkeit von dem Behandlungsgut zu entfernen oder abzuhalten. Dabei kann eine Rückhaltefläche zum Zurückhalten von Behandlungsflüssigkeit beabstandet zu einem Nutzbereich des Behandlungsgutes so angeordnet werden, dass ein Spalt ausgebildet ist, um einen direkten Kontakt des Nutzbereichs mit einem festen Element zu verringern oder zu vermeiden. Ausführungsbeispiele der Erfindung können insbesondere in Anlagen eingesetzt werden, in denen flächiges Behandlungsgut mit einer empfindlichen Oberfläche in einer horizontalen oder im Wesentlichen in einer horizontalen Transportebene transportiert wird. Jedoch sind die Ausführungsbeispiele nicht auf dieses Anwendungsgebiet beschränkt.

Die Erfindung wird nachfolgend anhand bevorzugter oder vorteilhafter Ausführungsbeispiele unter Bezugnahme auf die beigefügten Zeichnungen näher erläutert.
Fig. 1 ist eine schematische Vorderansicht einer Vorrichtung zum Entfernen oder Abhalten von Behandlungsflüssigkeit nach einem Ausführungsbeispiel.
Fig. 2 ist eine schematische, teilweise geschnittene Seitenansicht der Vorrichtung von Fig. 1.
Fig. 3 ist eine schematische, teilweise geschnittene Seitenansicht einer Vorrichtung zum Entfernen von Behandlungsflüssigkeit nach einem weiteren Ausführungsbeispiel.
Fig. 4 ist eine schematische, teilweise geschnittene Seitenansicht eines Abschnitts einer Behandlungsstation mit mehreren Vorrichtungen zum Entfernen von Behandlungsflüssigkeit nach einem Ausführungsbeispiel.
Fig. 5 ist eine schematische, teilweise geschnittene Seitenansicht eines Abschnitts einer Behandlungsstation mit mehreren Vorrichtungen zum Entfernen von Behandlungsflüssigkeit nach einem weiteren Ausführungsbeispiel.
Fig. 6 ist eine schematische Vorderansicht einer Vorrichtung zum Entfernen oder Abhalten von Behandlungsflüssigkeit nach einem weiteren Ausführungsbeispiel.
Fig. 7 ist eine schematische, teilweise geschnittene Seitenansicht einer Vorrichtung zum Entfernen von Behandlungsflüssigkeit nach einem weiteren Ausführungsbeispiel.
Fig. 8 ist eine schematische, teilweise geschnittene Seitenansicht einer Behandlungsstation mit Vorrichtungen zum Entfernen oder Abhalten von Behandlungsflüssigkeit nach einem Ausführungsbeispiel in einem Ein- und Auslaufbereich.
Fig. 9 ist eine schematische, teilweise geschnittene Seitenansicht einer Behandlungsstation mit Abquetschwalzenpaaren.

Richtungs- oder Positionsangaben, die sich auf das Behandlungsgut beziehen, werden konventionsgemäß in Bezug auf die Transportrichtung angegeben. Die Richtung, die beim Transportieren des Behandlungsgutes parallel bzw. antiparallel zur Transportrichtung ist, wird als Längsrichtung, die in der Transportebene liegende Richtung orthogonal zur Transportrichtung als Breitenrichtung des Behandlungsgutes bezeichnet.

Es werden Ausführungsbeispiele von Vorrichtungen und Verfahren beschrieben, bei denen Behandlungsflüssigkeit von einem Behandlungsgut abgehalten oder entfernt wird. Unter Behandlungsflüssigkeit wird jede Flüssigkeit verstanden, der das Behandlungsgut in einer Anlage zur nasschemischen Behandlung ausgesetzt werden kann, insbesondere eine Prozesschemikalie, eine Spülflüssigkeit wie Wasser oder dergleichen.

Die Ausführungsbeispiele werden im Kontext einer Anlage zum Behandeln von Behandlungsgut beschrieben, bei der das Behandlungsgut in einer horizontalen Transportebene transportiert wird. Angaben wie "oberhalb der Transportebene" oder "unterhalb der Transportebene", "obere Oberfläche", "untere Oberfläche" sowie Bezugnahmen auf eine Höhe oder ein Niveau von Behandlungsflüssigkeit und dergleichen sind entsprechend auf die Vertikalrichtung bezogen, sofern dies nicht anderweitig angegeben ist. Unter einem Transport in einer horizontalen Transportebene kann dabei insbesondere ein Transport von Behandlungsgut verstanden werden, bei dem wenigstens drei Ecken des Behandlungsgutes in einer horizontalen Ebene liegen. Dies schließt nicht aus, dass zumindest einzelne Abschnitt oder Bereiche des Behandlungsgutes beim Transportieren außerhalb der Transportebene liegen, beispielsweise bei einem Behandlungsgut mit geringer Eigensteifigkeit.

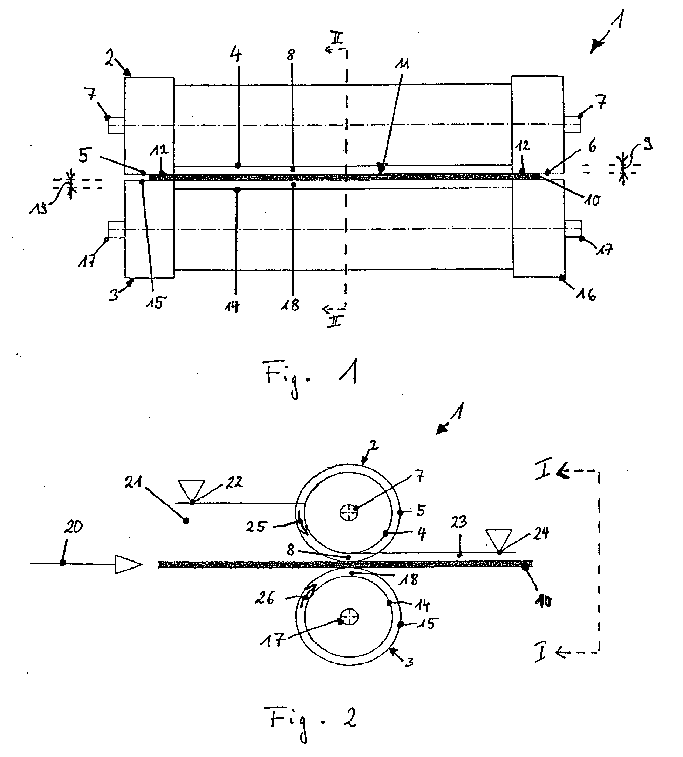

Fig. 1 ist eine schematische Vorderansicht einer Vorrichtung 1 zum Entfernen von Behandlungsflüssigkeit von einem Behandlungsgut 10. Fig. 2 ist eine schematische Seitenansicht der Vorrichtung 1 entlang der in Fig. 1 mit II-II bezeichneten Richtung. Die Schnittebene der teilweise geschnittenen Seitenansicht ist eine vertikale Ebene, die die Transportebene entlang einer Linie schneidet, an der ein Nutzbereich des Behandlungsgutes transportiert wird.

Die Vorrichtung 1 umfasst eine Walze 2 und eine weitere Walze 3, die an gegenüberliegenden Seiten einer Transportebene für das Behandlungsgut 10 so angeordnet sind, dass das Behandlungsgut 10 zwischen der Walze 2 und der weiteren Walze 3 transportiert wird. Die Vorrichtung 1 kann beispielsweise als Paar von Abquetschwalzen 213 oder 215 bei der Behandlungsstation 200 von Fig. 9 eingesetzt werden.

Die Walze 2 weist eine Rückhaltefläche 4 für Behandlungsflüssigkeit auf, die als abgesetzter Abschnitt der Mantelfläche der Walze 2 vorgesehen ist. Die Walze 2 ist relativ zu einem Transportweg des Behandlungsgutes 10 so positioniert, dass ein Spalt 8 zwischen der Rückhaltefläche 4 und dem Behandlungsgut 10 freibleibt, wenn das Behandlungsgut 10 an der Walze 2 vorbei transportiert wird. Der die Rückhaltefläche 4 bildende Abschnitt der Mantelfläche der Walze 2 kann im Wesentlichen zylinderförmig ausgebildet sein.

Die weitere Walze 3 weist eine weitere Rückhaltefläche 14 für die Behandlungsflüssigkeit auf, die als abgesetzter Abschnitt der Mantelfläche der Walze 3 vorgesehen ist. Die weitere Walze 3 ist relativ zu dem Transportweg des Behandlungsgutes 10 so positioniert, dass ein Spalt 18 zwischen der weiteren Rückhaltefläche 14 und dem Behandlungsgut 10 freibleibt, wenn das Behandlungsgut 10 an der Walze 3 vorbei transportiert wird. Der die weitere Rückhaltefläche 14 bildende Abschnitt der Mantelfläche der Walze 3 kann im Wesentlichen zylinderförmig ausgebildet sein.

Aufgrund der Spalte 8, 18, die durch die Anordnung und Ausgestaltung der Walze 2 und der weiteren Walze 3 ausgebildet werden, kommt ein Nutzbereich 11 des Behandlungsgutes 10, der sich über einen Großteil der Breitenrichtung des Behandlungsgutes 10 erstreckt, nicht mit festen Elementen der Vorrichtung 1 in Berührung. Die Gefahr einer Beschädigung der Oberflächen des Behandlungsgutes 10 im Nutzbereich 11 kann auf diese Weise verringert werden.

Aufgrund der Zylinderform der Rückhaltefläche 4 und der weiteren Rückhaltefläche 14 weisen die Spalte 8, 18 eine in Transportrichtung 20 des Behandlungsgutes 10 veränderliche Spalthöhe bzw. lichte Höhe auf. Eine minimale Spalthöhe 9, 19 der Spalte 8, 18 wird durch diejenigen Punkte der Rückhalteflächen 4, 14 bestimmt, die den geringsten Abstand zu der der jeweiligen Walze 2 bzw. 3 gegenüberliegenden Oberfläche des Behandlungsgutes 10 aufweisen.

Auch wenn die Spalte 8, 18 einen Durchtritt von Behandlungsflüssigkeit erlauben, kann mit der Vorrichtung 1 Behandlungsflüssigkeit von dem Behandlungsgut 10 entfernt werden. Insbesondere kann die Vorrichtung 1 durch die Verjüngung der Spalte 8, 18 bis auf die minimale Spalthöhe 9, 19 einen Druckverlust hervorrufen, der zu unterschiedlichen Flüssigkeitsniveaus der Behandlungsflüssigkeit an den beiden in Transportrichtung 20 gegenüberliegenden Seiten der Walze 2 führen kann.

Fig. 2 zeigt schematisch eine Behandlungsflüssigkeit 21, die an einer Seite der Walze 2 bis zu einem Niveau 22 angestaut ist, und einen nach dem Vorbeiführen des Behandlungsgutes 10 an der Vorrichtung 1 verbleibende Schicht von Behandlungsflüssigkeit 23, die ein niedrigeres Niveau 24 aufweist. Die Vorrichtung 1 kann insbesondere so eingerichtet sein, dass die Behandlungsflüssigkeit 21 an einer Seite der Walzen 2, 3 (in Fig. 2 auf der linken Seite der Walzen 2, 3) von der Rückhaltefläche 4 und der weiteren Rückhaltefläche 14 bis zu dem Niveau 22 angestaut wird, das unmittelbar an der Rückhaltefläche 4 höher als die minimale Spalthöhe 9 des Spaltes 8 und als die minimale Spalthöhe 19 des Spaltes 18, jeweils gemessen von der Unterkante des entsprechenden Spaltes 8, 18 an der Position mit minimaler Spalthöhe, ist.

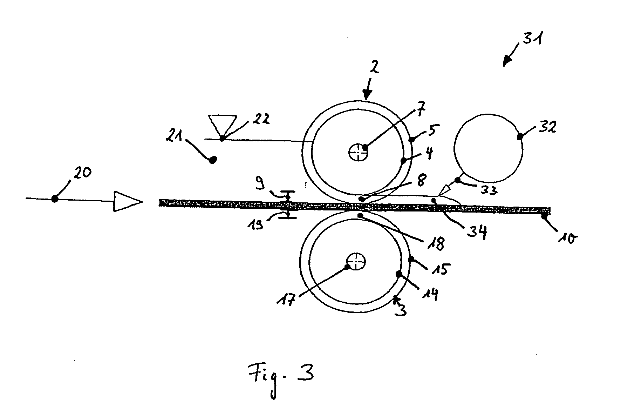

Wie unter Bezugnahme auf Fig. 3-6 noch näher erläutert werden wird, kann die nach dem Vorbeiführen des Behandlungsgutes 10 an den Rückhalteflächen 4, 14 noch an dem Behandlungsgut verbleibende Behandlungsflüssigkeit 23 auf geeignete Weise entfernt werden, beispielsweise durch Anströmen des Behandlungsgutes mit einem Fluidstrom.

Die Walzen 2, 3 der Vorrichtung 1 können nicht nur zum Entfernen von Flüssigkeit von dem Behandlungsgut 10, sondern auch zum Transportieren des Behandlungsgutes 10 eingerichtet sein. Dazu kann die Walze 2 an ihren beiden axialen Enden erhöhte Randabschnitte 5, 6 aufweisen, die in Anlage mit einem Randbereich 12 des Behandlungsgutes 10 gebracht werden, wenn das Behandlungsgut an den Walzen 2, 3 vorbeigeführt wird. Die erhöhten Randabschnitte 5, 6 können drehend angetrieben werden, um das Behandlungsgut 10 zu transportieren. Zum drehenden Antrieb der Randabschnitte 5, 6 ist eine Welle 7 vorgesehen, die bei Verwendung der Vorrichtung 1 in einer Behandlungsanlage für das Behandlungsgut 10 drehbar gelagert ist. Durch Drehung der Randabschnitte 5, 6 in einer Drehrichtung 25 kann das Behandlungsgut 10 weitertransportiert werden. Entsprechend kann die Walze 3 an ihren beiden axialen Enden erhöhte Randabschnitte 15, 16 aufweisen, die in Anlage mit einem Randbereich 12 des Behandlungsgutes 10 gebracht werden, wenn das Behandlungsgut an den Walzen 2, 3 vorbeigeführt wird. Die erhöhten Randabschnitte 15, 16 können drehend angetrieben werden, um das Behandlungsgut 10 zu transportieren. Zum drehenden Antrieb der Randabschnitte 15, 16 ist eine Welle 17 vorgesehen, die bei Verwendung der Vorrichtung 1 in einer Behandlungsanlage für das Behandlungsgut 10 drehbar gelagert ist. Durch Drehung der Randabschnitte 15, 16 in einer Drehrichtung 26 kann das Behandlungsgut 10 weitertransportiert werden.

Die Randabschnitte 5, 6 und/oder die Randabschnitte 15, 16 können in einem Reibschluss und/oder in einem Formschluss mit dem Behandlungsgut 10 stehen, um dieses zu transportieren. Beispielsweise können an den Randabschnitten 5, 6 und/oder an den Randabschnitten 15, 16 Vorsprünge ausgebildet sein, die in korrespondierende Ausnehmungen des Behandlungsgutes 10 eingreifen, um das Behandlungsgut 10 zu transportieren.

Bei der Walze 2 wirken die erhöhten Randabschnitte 5, 6 als Transportabschnitte, die zum Transportieren des Behandlungsgutes 10 mit dem Behandlungsgut 10 gekoppelt werden können. Die Rückhaltefläche 4 ist relativ zu den Randabschnitten 5, 6 abgesetzt. Die Erhöhung bzw. der im Vergleich zum Radius der Rückhaltefläche 4 größere Radius der Randabschnitte 5, 6 bestimmt die minimale Spalthöhe 9. Entsprechend wirken bei der Walze 3 die erhöhten Randabschnitte 15, 16 als Transportabschnitte, die zum Transportieren des Behandlungsgutes 10 mit dem Behandlungsgut 10 gekoppelt werden können. Die Rückhaltefläche 14 ist relativ zu den Randabschnitten 15, 16 abgesetzt. Die Erhöhung bzw. der im Vergleich zum Radius der Rückhaltefläche 14 größere Radius der Randabschnitte 15, 16 bestimmt die minimale Spalthöhe 19.

Die Radien der Randabschnitte und der Rückhaltefläche können für das gewünschte Anwendungsgebiet geeignet gewählt werden. Beispielsweise kann der Radius des die Rückhaltefläche bildenden Abschnitts der Walze 2, 3 um weniger als 1 mm, insbesondere um weniger als 0,7 mm, insbesondere um weniger als 0,5 mm kleiner als der Radius der Randabschnitte der Walze 2, 3 sein, die als Transportabschnitte dienen. Der Radius des die Rückhaltefläche bildenden Abschnitts der Walze 2, 3 kann um mindestens 0,05 mm, insbesondere um mindestens 0,07 mm, insbesondere um mindestens 0,09 mm kleiner als der Radius der Randabschnitte der Walze 2, 3 sein, die als Transportabschnitte dienen.

Zusätzlich kann die Welle 7 der Walze 2 und/oder die Welle 17 der weiteren Walze 3 mit einem höhenverstellbaren Lager derart gelagert sein, dass ein Abstand der Welle 7 von der oberen Oberfläche des Behandlungsgutes 10 und/oder ein Abstand der Welle 17 von der unteren Oberfläche des Behandlungsgutes 10 eingestellt werden kann.

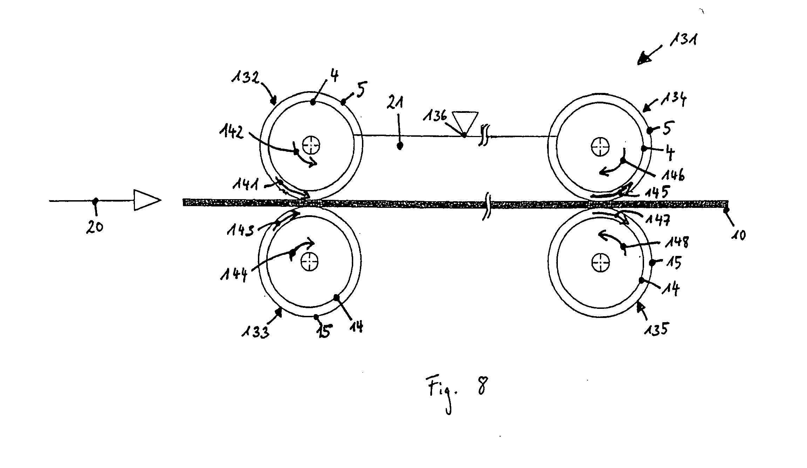

Die Walze 2 und die weitere Walze 3 können so eingerichtet sein, dass sich bei Drehung der als Transportabschnitte dienenden Randabschnitte 5, 6 bzw. 15, 16 auch die Rückhalteflächen 4 bzw. 14 der jeweiligen Walze gleichsinnig mit den Transportabschnitte der jeweiligen Walze drehen. Auf diese Weise kann eine Relativbewegung zwischen den Rückhalteflächen 4 und 14 und der Oberfläche des Behandlungsgutes 10 verringert werden. Dazu können die Walze 2 bzw. die Walze 3 beispielsweise so ausgestaltet sein, dass sowohl die Transportabschnitte als auch die Rückhaltefläche an ihrer Oberfläche drehfest zueinander ausgebildet sind. Alternativ können jedoch die Transportabschnitte relativ zu der Rückhaltefläche drehbar vorgesehen sein, wie unter Bezugnahme auf Fig. 8 noch näher erläutert werden wird.

Bei einem Ausführungsbeispiel können die Transportabschnitte relativ zu der Rückhaltefläche drehbar vorgesehen sein. Eine Winkelgeschwindigkeit der Rückhaltefläche kann abhängig von einer Winkelgeschwindigkeit der Transportabschnitte, einem Radius der Transportabschnitte und einem Radius des die Rückhaltefläche bildenden Abschnitts der Walze ausgewählt werden. Die Winkelgeschwindigkeit der Rückhaltefläche kann so gewählt sein, dass die Umfangsgeschwindigkeit an der Rückhaltefläche gleich der Transportgeschwindigkeit des Behandlungsgutes ist.

Mehrere Abwandlungen der Vorrichtung 1 können bei weiteren Ausführungsbeispielen realisiert werden.

Während beispielsweise die Walzen 2, 3 der Vorrichtung 1 an ihren axialen Enden Erhöhungen 5, 6, 15, 16 aufweisen, können an der Walze 2 und/oder an der weiteren Walze 3 auch mehr als zwei erhöhte Abschnitte vorgesehen sein. Die weiteren erhöhten Abschnitte können dabei insbesondere so an der Walze 2 und/oder an der weiteren Walze 3 angeordnet sein, dass sie das Behandlungsgut 10 an Oberflächenbereichen berühren, an denen ein derartiger mechanischer Kontakt unkritisch ist. Beispielsweise können in Längsrichtung des Behandlungsgutes 10 verlaufende Oberflächenbereiche des Behandlungsgutes mit weiteren Erhöhungen der Walze 2 und/oder der weiteren Walze 3 abgestützt werden. Der Nutzbereich 11 des Behandlungsgutes 10 kann durch diejenigen Oberflächenbereiche des Behandlungsgutes definiert sein, die nicht von Erhöhungen der Walze 2 oder der weiteren Walze 3 berührt werden. Die zusätzliche Stützwirkung, die durch die weiteren Erhöhungen bewirkt wird, kann die Gefahr einer unerwünschten Berührung des Behandlungsgutes 10 in seinem Nutzbereich verringern.

Während bei der Vorrichtung 1 Rückhalteflächen 4, 14, die einen Spalt mit einer Oberfläche des Behandlungsgutes ausbilden, sowohl oberhalb als auch unterhalb der Transportebene vorgesehen sind, kann bei einer Vorrichtung nach einem weiteren Ausführungsbeispiel auch nur an einer Seite eine Rückhaltefläche vorgesehen sein, die mit einer Oberfläche des Behandlungsgutes einen Spalt ausbildet. Beispielsweise kann eine derartige spaltbildende Rückhaltefläche nur an der Oberseite oder nur an der Unterseite der Transportebene angeordnet sein. An der gegenüberliegenden Seite kann beispielsweise eine Walze vorgesehen sein, die einen im Wesentlichen konstanten Durchmesser aufweist. Die Walze kann dann eine Oberfläche des Behandlungsgutes im Nutzbereich des Behandlungsgutes berühren. Die an der anderen Seite vorgesehene spaltbildende Rückhaltefläche kann zu einer Reduzierung der auf die Oberflächen des Behandlungsgutes ausgeübten Kräfte führen, um die Gefahr einer Beschädigung der Oberflächen zu verringern.

Bei einem weiteren Ausführungsbeispiel kann auch eine Mantelfläche einer Walze mit einem Durchmesser, der konstant ist, d.h. der nicht entlang der Axialrichtung der Walze variiert, als Rückhaltefläche dienen, die einen Spalt zwischen der Rückhaltefläche und der Oberfläche des Behandlungsgutes definiert. Die Ausgestaltung des Spaltes, insbesondere die minimale Spalthöhe, kann einstellbar gemacht werden, indem die Walze mit einem Lager gelagert ist, das relativ zu der Transportebene höhenverstellbar ist. Es können auch zwei derartige Walzen vorgesehen sein, um an der Ober- und an der Unterseite des Behandlungsgutes Flüssigkeit zu entfernen, wobei ein Spalt zwischen der entsprechenden Walze und dem Behandlungsgut ausgebildet bleibt.

Fig. 3 ist eine schematische Seitenansicht einer Vorrichtung 31 zum Entfernen von Behandlungsflüssigkeit nach einem weiteren Ausführungsbeispiel. Die Vorrichtung 31 kann beispielsweise im Auslaufbereich der Behandlungsstation 200 von Fig. 9 anstelle der Paare von Abquetschwalzen 214, 215, 216 verwendet werden. Elemente oder Einrichtungen der Vorrichtung 31, die in ihrer Funktion und/oder Ausgestaltung Elementen oder Einrichtungen der Vorrichtung 1 entsprechen, sind mit denselben Bezugszeichen versehen und werde nicht erneut eingehend erläutert.

Die Vorrichtung 31 umfasst eine Rückhaltefläche 4 zum Zurückhalten von Flüssigkeit. Die Vorrichtung 31 ist so eingerichtet, dass die Rückhaltefläche 4 mit der ihr gegenüberliegenden Oberfläche eines Behandlungsgutes 10 (in Fig. 3 mit der oberen Oberfläche des Behandlungsgutes 10) einen Spalt 8 ausbildet. Die Rückhaltefläche 4 kann beispielsweise an einer drehbar gelagerten Walze 2 vorgesehen sein. Die Walze 2 kann wie unter Bezugnahme auf Fig. 1 und 2 beschrieben ausgestaltet sein. Die Rückhaltefläche 4 entfernt Behandlungsflüssigkeit von dem an der Rückhaltefläche 4 vorbeitransportierten Behandlungsgut 10. Da der Spalt 8 bei einem Ausführungsbeispiel den Durchtritt von Behandlungsflüssigkeit erlaubt, kann auch noch Behandlungsflüssigkeit 34 an dem Behandlungsgut 10 vorhanden sein, nachdem dieses die Walze 2 mit der Rückhaltefläche 4 passiert hat.

Die Vorrichtung 31 umfasst weiterhin eine Anströmeinrichtung 32 mit einer Düsenanordnung. Die Anströmeinrichtung 32 ist in Transportrichtung beabstandet von der Walze 2 und der an der Walze 2 vorgesehenen Rückhaltefläche 4 angeordnet. Die Anströmeinrichtung 32 ist in Transportrichtung stromabwärts, d.h. in Transportrichtung nach, der Walze 2 mit der Rückhaltefläche 4 angeordnet. Die Anströmeinrichtung 32 ist eingerichtet, um einen Teil der Behandlungsflüssigkeit 34, die nach Passieren des Spaltes 8 an dem Behandlungsgut 10 verblieben ist, von dem Behandlungsgut 10 zu entfernen. Die Anströmeinrichtung 32 kann insbesondere eingerichtet sein, um einen Großteil der Behandlungsflüssigkeit 34, die nach Passieren des Spaltes 8 an dem Behandlungsgut 10 verblieben ist, von dem Behandlungsgut 10 zu entfernen.

Die Anströmeinrichtung 32 kann einen Fluidstrom 33, insbesondere einen Gasstrom, beispielsweise einen Luftstrom, ausgeben, um die Behandlungsflüssigkeit 34 von dem Behandlungsgut 10 abzublasen oder anderweitig mit dem Fluidstrom 33 zu entfernen. Der Fluidstrom 33 kann zumindest eine Strömungskomponente in Richtung der spalterzeugenden Rückhaltefläche 4 der Vorrichtung 31 aufweisen (in Fig. 3 eine nach links gerichtete Komponente). An der Rückhaltefläche 4 kann die Behandlungsflüssigkeit seitlich von dem Behandlungsgut strömen.

Die Anströmeinrichtung kann auch so eingerichtet sein, dass der Fluidstrom 33 eine Strömungskomponente aufweist, die parallel zu der Transportebene und quer zu der Transportrichtung 20 gerichtet ist, d.h. parallel zu der Axialrichtung der Walze 2 weist, an der die Rückhaltefläche 4 ausgebildet ist. Auf diese Weise kann die Behandlungsflüssigkeit 34 seitlich von dem Behandlungsgut 10 entfernt werden.

Die Anströmeinrichtung 32 kann sich über die gesamte Breite des Behandlungsgutes 10, d.h. über die Ausdehnung des Behandlungsgutes 10 quer zu der Transportrichtung, über das Behandlungsgut 10 erstrecken. Zum Ausgeben des Fluidstroms 33 kann die Anströmeinrichtung 32 eine oder mehrere Düsenöffnungen aufweisen. Die Düsenöffnungen können beispielsweise als ein durchgehender Schlitz, mehrere Schlitze oder eine Vielzahl von Bohrungen ausgebildet sein, der bzw. die in Breitenrichtung des Behandlungsgutes 10 an der Anströmeinrichtung 32 ausgebildet ist bzw. sind. Die Anströmeinrichtung 32 kann so ausgestaltet sein, dass der Abstand der Düsenöffnungen zu der Oberfläche des Behandlungsgutes 10 über die gesamte Breite des Behandlungsgutes im Wesentlichen gleich groß ist.

Die Anströmeinrichtung 32 kann einen geraden Kanalkörper umfassen, welcher parallel zur Transportebene und quer zu der Transportrichtung 20 gerichtet ist. Der Kanalkörper kann alternativ auch parallel zur Transportebene und schräg zu der Transportrichtung 20 ausgerichtet sein.

Bei einem Ausführungsbeispiel kann die Anströmeinrichtung 32 so ausgeformt sein, dass ein in Breitenrichtung des Behandlungsgutes mittlerer Abschnitt der Anströmeinrichtung 32 näher an der spaltbildenden Rückhaltefläche 4 angeordnet ist als ein Randabschnitt der Anströmeinrichtung 32. Beispielsweise kann die Anströmeinrichtung 32 eine Form aufweisen, die in einer Draufsicht aus einer Richtung senkrecht zu der Transportebene (d.h. in Fig. 3 bei Blick senkrecht von oben auf die Transportebene) eine zu dem von der Rückhaltefläche 4 ausgebildeten Spalt 8 hin konvexe Form aufweist. Beispielsweise kann die Anströmeinrichtung 32 in Draufsicht eine V-Form aufweisen, deren Spitze zur Rückhaltefläche 4 hin zeigt. Eine so ausgebildete Anströmeinrichtung ist eingerichtet, um den Fluidstrom mit einer Geschwindigkeitskomponente in Richtung eines Randes des Behandlungsgutes auszugeben, um in effektiver Weise die Behandlungsflüssigkeit zu dem Rand des Behandlungsgutes hin zu befördern und so zu entfernen.

Die Anströmeinrichtung 32 kann eingerichtet sein, um einen Gasstrom, insbesondere einen Luftstrom, auszugeben und das Behandlungsgut damit anzuströmen. Die Anströmeinrichtung 32 kann so eingerichtet sein, dass eine Ausströmgeschwindigkeit des Gasstromes 33 mindestens 2 m/sec, insbesondere mindestens 10 m/sec, insbesondere mindestens 30 m/sec beträgt.

Die Anströmeinrichtung 32 kann auch eingerichtet sein, um einen Flüssigkeitsstrom auszugeben und das Behandlungsgut damit anzuströmen. Die Anströmeinrichtung 32 kann so eingerichtet sein, dass eine Ausströmgeschwindigkeit des Flüssigkeitsstromes 33 mindestens 0,1 m/sec, insbesondere mindestens 1 m/sec, insbesondere mindestens 3 m/sec beträgt.

Die Anströmeinrichtung 32 kann so eingerichtet sein, dass eine Ausströmrichtung des Fluidstromes 33 parallel oder schräg zu der Oberfläche des Behandlungsgutes sein kann. Insbesondere kann die Anströmeinrichtung 32 so ausgebildet sein, dass der Fluidstrom aus den Düsenöffnungen der Anströmeinrichtung 32 in Richtung des Spaltes 8 und/oder quer zu der Transportrichtung in Richtung eines Randes des Behandlungsgutes 10 ausströmt. Alternativ kann die Ausströmrichtung auch senkrecht auf die Oberfläche des Behandlungsgutes 10 gerichtet sein.

Die Anströmeinrichtung 32 kann so ausgebildet sein, dass der Fluidstrom 33 nicht durch den Spalt 8 hindurchtritt, d.h. nicht in die auf der entgegengesetzten Seite der spaltbildenden Rückhaltefläche 4 angestaute Behandlungsflüssigkeit eintritt. Auf diese Weise kann vermieden oder unterdrückt werden, dass der Fluidstrom 33 eine Blasenbildung in der Behandlungsflüssigkeit 21 hervorruft. Um den Durchtritt des Fluidstroms 33 durch den Spalt 8 zu vermeiden, kann beispielsweise einer oder eine oder mehrere von einem Volumenstrom, der Ausströmgeschwindigkeit und/oder der Ausströmrichtung des Fluidstroms 33 aus der Anströmeinrichtung 32 entsprechend eingestellt werden.

Die Vorrichtung 31 kann so ausgebildet sein, dass ein Abstand oder die verschiedenen Abstände zwischen dem Spalt 8 und der Düsenöffnung bzw. den Düsenöffnungen der Anströmeinrichtung 32 höchstens 100 mm und mindestens 10 mm beträgt bzw. betragen.

Wie in Fig. 3 dargestellt kann die Vorrichtung 31 weiterhin eine unterhalb der Transportebene angeordnete weitere Rückhaltefläche 14 aufweisen, die an einer weiteren Walze 3 ausgebildet sein kann.

Mehrere Abwandlungen der Vorrichtung 31 können bei weiteren Ausführungsbeispielen realisiert werden. Während beispielsweise unter Bezugnahme auf Fig. 3 eine Vorrichtung 31 zum Entfernen von Behandlungsflüssigkeit erläutert wurde, bei der die Anströmeinrichtung 32 in Transportrichtung des Behandlungsgutes 10 der Walze 2 mit der spaltbildenden Rückhaltefläche 4 nachgeordnet ist, kann eine Vorrichtung zum Abhalten von Behandlungsflüssigkeit auch so ausgestaltet sein, dass die Anströmeinrichtung in Transportrichtung des Behandlungsgutes vor bzw. stromaufwärts der spaltbildenden Rückhaltefläche angeordnet ist. Eine so ausgebildete Vorrichtung kann insbesondere in einem Einlaufbereich einer Behandlungsstation verwendet werden.

Bei einer Vorrichtung zum Entfernen oder Abhalten von Behandlungsflüssigkeit nach einem weiteren Ausführungsbeispiel kann die Anströmeinrichtung 32 alternativ oder zusätzlich unterhalb der Transportebene vorgesehen sein, um Flüssigkeit von einer Unterseite des Behandlungsgutes 10 abzublasen oder anderweitig mit dem von der Anströmeinrichtung abgegebenen Fluidstrom 33 von dem Behandlungsgut 10 zu entfernen.

Falls die Anströmeinrichtung unterhalb der Transportebene vorgesehen ist, kann sie so ausgestaltet sein, dass der von der Anströmeinrichtung erzeugte Fluidstrom eine Geschwindigkeitskomponente parallel zu der Transportrichtung aufweist, die weg von der spalterzeugenden Rückhaltefläche gerichtet ist. Beispielsweise kann bei einer in einem Auslaufbereich einer Behandlungsstation vorgesehenen Anströmeinrichtung der von der Anströmeinrichtung erzeugte Fluidstrom eine in Transportrichtung gerichtete Geschwindigkeitskomponente aufweisen.

Falls eine Anströmeinrichtung zum Entfernen von Behandlungsflüssigkeit oberhalb der Transportebene vorgesehen ist, kann an der entsprechenden Position unterhalb der Transportebene ein Trannsportelement vorgesehen sein. Ähnlich kann, falls eine Anströmeinrichtung zum Entfernen von Behandlungsflüssigkeit unterhalb der Transportebene vorgesehen ist, an der entsprechenden Position oberhalb der Transportebene ein Trannsportelement vorgesehen sein. Das Transportelement und die Anströmeinrichtung können an derselben Position in Transportrichtung an entgegengesetzten Seiten der Transportebene angeordnet sein.

Das Transportelement kann beispielsweise eingerichtet sein, um das Behandlungsgut abzustützen und/oder zu transportieren. Das Transportelement kann als Walze ausgebildet sein. Die Walze kann eine abgesetzte Rückhaltefläche aufweisen, kann aber auch einen in Axialrichtung im Wesentlichen konstanten Durchmesser aufweisen. Das Transportelement kann auch als Rädchenachse ausgebildet sein, an der mehrere Rädchen vorgesehen sind. Die Rädchen können ausgestaltet sein, um das Behandlungsgut zum Transportieren des Behandlungsgutes zu berühren.

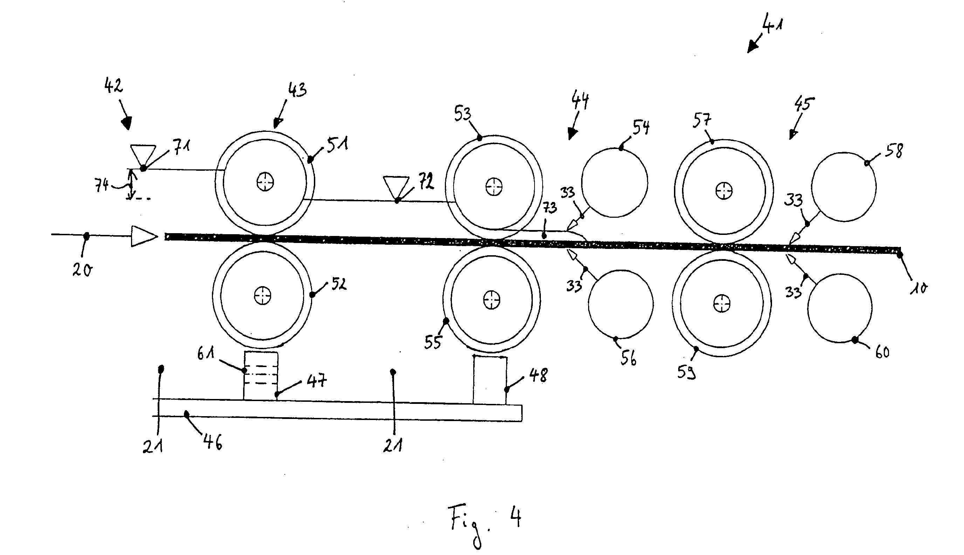

Fig. 4 ist eine schematische Seitenansicht eines Auslaufbereichs 41 einer Behandlungsstation. Ein derartiger Auslaufbereich 41 kann bei der Behandlungsstation 200 von Fig. 9 an einem Ende des Innenbehälters 201 vorgesehen werden, an dem das Behandlungsgut die Behandlungsstation verlässt. In dem Auslaufbereich wird ein Behandlungsgut 10 aus einem Behandlungsbereich 42, in dem eine Behandlungsflüssigkeit 21 so hoch angestaut ist, dass das Behandlungsgut eingetaucht ist, in einer Transportrichtung 20 weitertransportiert.

Der Auslaufbereich 41 umfasst mehrere Vorrichtungen 43, 44 und 45 zum Entfernen von Behandlungsflüssigkeit von dem Behandlungsgut 10. Die Vorrichtungen 43, 44 und 45 zum Entfernen der Behandlungsflüssigkeit sind voneinander in Transportrichtung 20 beabstandet entlang einem Transportweg des Behandlungsgutes 10 angeordnet. Jede der Vorrichtungen 43, 44 und 45 kann eine Rückhaltefläche aufweisen, die relativ zu der Transportebene so angeordnet ist, dass ein Spalt zwischen der Rückhaltefläche und der ihr gegenüberliegenden Oberfläche des Behandlungsgutes 10 ausgebildet wird.

Die Vorrichtungen 43, 44 und 45 können als Vorrichtungen zum Entfernen von Behandlungsflüssigkeit nach einem Ausführungsbeispiel ausgebildet sein. Bei einem Ausführungsbeispiel kann die Vorrichtung 43 ein Paar von Walzen 51, 52 umfassen, die so angeordnet sind, dass das Behandlungsgut 10 dazwischen durchgeführt werden kann. An wenigstens einer der Walzen 51, 52 der Vorrichtung 43 kann eine spaltbildende Rückhaltefläche zum Zurückhalten der Behandlungsflüssigkeit so ausgebildet sein, dass ein Spalt zwischen der Rückhaltefläche und der ihr gegenüberliegenden Oberfläche des Behandlungsgutes 10 ausgebildet wird, wenn das Behandlungsgut an den Walzen 51, 52 vorbeigeführt wird. Insbesondere kann wenigstens eine der Walzen 51, 52 erhöhte Randbereiche zum Transportieren des Behandlungsgutes 10 und eine dazwischen vorgesehene abgesetzte Rückhaltfläche aufweisen. Die Vorrichtung 43 kann beispielsweise wie die unter Bezugnahme auf Fig. 1 und 2 erläuterte Vorrichtung 1 ausgebildet sein.

Die Vorrichtung 44 kann eine oberhalb des Transportebene angeordnete Walze 53 und Anströmeinrichtung 54 und eine unterhalb der Transportebene angeordnete Walze 55 und Anströmeinrichtung 56 aufweisen. An wenigstens einer der Walzen 53, 55 der Vorrichtung 44 kann eine spaltbildende Rückhaltefläche zum Zurückhalten der Behandlungsflüssigkeit so ausgebildet sein, dass ein Spalt zwischen der Rückhaltefläche und der ihr gegenüberliegenden Oberfläche des Behandlungsgutes 10 ausgebildet wird, wenn das Behandlungsgut an den Walzen 53, 55 vorbeigeführt wird. Insbesondere kann wenigstens eine der Walzen 53, 55 erhöhte Randbereiche zum Transportieren des Behandlungsgutes 10 und eine dazwischen vorgesehene abgesetzte Rückhaltfläche aufweisen, wie unter Bezugnahme auf Fig. 1 und 2 erläutert. Die Anströmeinrichtungen 54 und 56 strömen das Behandlungsgut 10 mit einem Fluidstrom 33, beispielsweise einem Luftstrom an, um an dem Behandlungsgut verbliebene Behandlungsflüssigkeit zu entfernen. Dazu können die von den Anströmeinrichtungen 54 und 56 abgegebenen Fluidströme 33 so gerichtet sein, dass sie die Behandlungsflüssigkeit in Richtung eines Randes des Behandlungsgutes bewegen und so entfernen.

Die Vorrichtung 45 kann eine oberhalb des Transportebene angeordnete Walze 57 und Anströmeinrichtung 58 und eine unterhalb der Transportebene angeordnete Walze 59 und Anströmeinrichtung 60 aufweisen. An wenigstens einer der Walzen 57, 59 der Vorrichtung 45 kann eine spaltbildende Rückhaltefläche zum Zurückhalten der Behandlungsflüssigkeit so ausgebildet sein, dass ein Spalt zwischen der Rückhaltefläche und der ihr gegenüberliegenden Oberfläche des Behandlungsgutes 10 ausgebildet wird, wenn das Behandlungsgut an den Walzen 57, 59 vorbeigeführt wird. Insbesondere kann wenigstens eine der Walzen 57, 59 erhöhte Randbereiche zum Transportieren des Behandlungsgutes 10 und eine dazwischen vorgesehene abgesetzte Rückhaltfläche aufweisen, wie unter Bezugnahme auf Fig. 1 und 2 erläutert. Die Anströmeinrichtungen 58 und 60 strömen das Behandlungsgut 10 mit einem Fluidstrom 33, beispielsweise einem Luftstrom an, um an dem Behandlungsgut verbliebene Behandlungsflüssigkeit zu entfernen. Dazu können die von den Anströmeinrichtungen 58 und 60 abgegebenen Fluidströme 33 so gerichtet sein, dass sie die Behandlungsflüssigkeit in Richtung eines Randes des Behandlungsgutes bewegen und so entfernen.

Die spaltbildenden Rückhalteflächen der Vorrichtungen 43, 44 und 45, die das Behandlungsgut 10 nacheinander passiert, können eine unterschiedliche Ausgestaltung aufweisen. Beispielsweise können die Spalte an den Vorrichtungen zunehmend enger werden. Beispielsweise kann die Vorrichtung 43 so ausgestaltet sein, dass ein Spalt mit einer ersten minimalen Spalthöhe zwischen der Rückhaltefläche der Vorrichtung 43 und der gegenüberliegenden Oberfläche des Behandlungsgutes 10 ausgebildet wird, während die der Vorrichtung 43 in Transportrichtung nachgeordnete Vorrichtung 44 so ausgestaltet sein kann, dass ein Spalt mit einer zweiten minimalen Spalthöhe zwischen der Rückhaltefläche der Vorrichtung 44 und der gegenüberliegenden Oberfläche des Behandlungsgutes 10 ausgebildet wird. Dabei kann die zweite minimale Spalthöhe an der Vorrichtung 44 kleiner sein als die erste minimale Spalthöhe an der Vorrichtung 43, d.h. die Spalte können im Auslaufbereich der Behandlungsstation von einer Vorrichtung zu einer dieser in Transportrichtung nachgeordneten anderen Vorrichtung zum Entfernen von Behandlungsflüssigkeit eine kleinere Höhe aufweisen.

Die Vorrichtung 43, die den Behandlungsbereich 42 begrenzt, ist so eingerichtet, dass ein Niveauunterschied 74 der Behandlungsflüssigkeit zwischen den in Transportrichtung entgegengesetzten Seiten der Walze 51 eingestellt wird. In dem Behandlungsbereich 42 ist die Behandlungsflüssigkeit 21 bis zu einem Niveau 71 angestaut, während in dem benachbarten Bereich an der anderen Seite der Walze 51 die Behandlungsflüssigkeit bis zu einem Niveau 72 angestaut ist.

Die Vorrichtung 44, die in Transportrichtung der Vorrichtung 43 nachgeordnet ist, ist so eingerichtet, dass Behandlungsflüssigkeit von dem Behandlungsgut 10 entfernt wird, wenn das Behandlungsgut 10 die Walzen 53, 55 passiert. Behandlungsflüssigkeit 73, die nach dem Vorbeiführen des Behandlungsgutes 10 an den Walzen 53, 55 noch an dem Behandlungsgut 10 vorhanden ist, wird durch die Anströmeinrichtungen 54, 56 zumindest teilweise entfernt. Durch die Vorrichtung 45, die in Transportrichtung der Vorrichtung 44 nachgeordnet ist, kann ein weiterer Teil der Behandlungsflüssigkeit von dem Behandlungsgut entfernt werden, der nach dem Durchlaufen der Vorrichtung 44 noch an dem Behandlungsgut 10 vorhanden sein kann.

Durch die Verwendung mehrerer Vorrichtungen zum Entfernen von Behandlungsflüssigkeit kann Behandlungsflüssigkeit zuverlässig von dem Behandlungsgut 10 entfernt werden, selbst wenn Spalte zwischen den Rückhalteflächen und dem Behandlungsgut 10 freibleiben.

Zwischen einem Boden 46 eines Innenbehälters der Behandlungsstation und der unterhalb der Transportebene angeordneten Walze 52 der Vorrichtung 43 ist ein Wehr 47 vorgesehen. Mit dem Wehr 47 kann ein Niveauunterschied 74 zwischen den Flüssigkeitsniveaus 71, 72 an den beiden Seiten der Vorrichtung 43 eingestellt werden. Dazu sind in dem Wehr 47 Öffnungen 61, beispielsweise in der Form von Langlöchern, Bohrungen oder Schlitzen ausgebildet. Die Öffnungen 61 können verschließbar sein, um den Flüssigkeitsdurchtritt durch das Wehr 47 einzustellen und somit den Niveauunterschied 74 zwischen den Flüssigkeitsniveaus 71 und 72 einzustellen.

Das Niveau 72 in dem dem Behandlungsbereich 42 benachbarten Bereich wird bestimmt durch ein Gleichgewicht aus zu- und ablaufenden Strömen von Behandlungsflüssigkeit. Um diese und somit das Niveau 72 einstellen zu können, können in dem Boden 46 zwischen den Wehren 47, 48 eine oder mehrere Öffnungen, beispielsweise verschließbare Bohrungen, vorgesehen sein. Durch geeignete Wahl der in dem Wehr 47 geöffneten Öffnungen und der in dem Boden 46 geöffneten Öffnungen kann eine Grundeinstellung für ein gewünschtes Niveau 72 in dem dem Behandlungsbereich 42 benachbarten Bereich gewählt werden. Zusätzlich können an Elementen, die die Behandlungsstation seitlich begrenzen, beispielsweise an Lageraufnahmen, die für die Lagerung der Walzen 51, 52, 53 und 55 vorgesehen sind, Überlaufwehre vorgesehen werden. Zusätzlich zulaufende Flüssigkeitsmengen können über die Überlaufwehre abgeführt werden.

Um den aus dem Behandlungsbereich 42 ablaufenden Strom von Behandlungsflüssigkeit auszugleichen, kann mit einer (nicht dargestellten) Pumpe Behandlungsflüssigkeit in den Behandlungsbereich 42 gefördert werden.

Zwischen dem Boden 46 des Innenbehälters der Behandlungsstation und der unterhalb der Transportebene angeordneten Walze 55 der Vorrichtung 44 ist ein Wehr 48 vorgesehen. Das Wehr 48 muss keine verschließbaren Öffnungen zum Einstellen des Flüssigkeitsniveaus aufweisen. Das Wehr 48 hilft mit, um ein Abfließen der Behandlungsflüssigkeit aus dem Behandlungsbereich zu verringern.

Bei weiteren Ausführungsbeispielen können Abwandlungen des Auslaufbereichs 41 realisiert sein. Bei einem Ausführungsbeispiel kann beispielsweise die Vorrichtung 45 weggelassen sein. Entsprechend können in dem Auslaufbereich zwei Vorrichtungen zu Entfernen von Behandlungsflüssigkeit vorgesehen sein. Wenigstens die in Transportrichtung letzte dieser Vorrichtungen kann eine Anströmeinrichtung aufweisen. Die Anströmeinrichtung kann zumindest oberhalb der Transportebene vorgesehen sein.

Bei einem weiteren Ausführungsbeispiel können mehrere Vorrichtungen zum Entfernen von Flüssigkeit vorgesehen sein, die ein Wehr mit einer Öffnung oder mehreren Öffnungen zum Einstellen eines Niveauunterschieds aufweisen. Das Wehr kann jeweils eine Ausgestaltung aufweisen, wie sie unter Bezugnahme auf das Wehr 47 erläutert wurde. Bei einem Ausführungsbeispiel können beispielsweise im Ein- oder Auslaufbereich zwei Vorrichtungen mit jeweils mindestens einer Walze vorgesehen sein, die eine Rückhaltefläche zum Zurückhalten von Flüssigkeit aufweist, die einen Spalt mit dem daran vorbeigeführten Behandlungsgut ausbildet, wobei bei jeder der Vorrichtungen unterhalb der Transportebene ein Wehr mit einer Öffnung oder mehreren Öffnungen vorgesehen ist, wie dies für das Wehr 47 beschrieben wurde. In Transportrichtung beabstandet zu diesen beiden Vorrichtungen kann eine weitere Vorrichtung vorgesehen sein, die eine der Vorrichtung 44 entsprechende Ausgestaltung aufweist. Auf diese Weise können beispielsweise in einem Ein- oder Auslaufbereich mindestens zwei Bereiche mit gegenüber dem Behandlungsbereich abgesenktem Niveau der Behandlungsflüssigkeit ausgebildet werden.

Während bei den Vorrichtungen 43-45 zum Entfernen von Flüssigkeit sowohl oberhalb als auch unterhalb der Transportebene jeweils eine Walze vorgesehen ist, die einen Spalt mit dem daran vorbeigeführten Behandlungsgut ausbildet, kann bei einem weiteren Ausführungsbeispiel jede der Vorrichtungen zum Entfernen von Flüssigkeit so ausgebildet sein, dass nur an den oberhalb der Transportebene vorgesehenen Walze eine Rückhaltefläche vorgesehen ist, die einen Spalt zwischen der Rückhaltefläche und dem daran vorbeigeführten Behandlungsgut freilässt. Die unterhalb der Transportebene vorgesehenen Walzen können einen in Axialrichtung der Walzen konstanten Durchmesser aufweisen.

Bei einem Ausführungsbeispiel kann eine der Anströmeinrichtungen 54, 56 durch ein Transportelement ersetzt sein. Das Transportelemenet kann eingerichtet sein, um das Behandlungsgut abzustützen und/oder zu transportieren. Das Transportelement kann beispielsweise als Walze oder als Rädchenachse ausgebildet sein. Alternativ oder zusätzlich kann eine der Anströmeinrichtungen 58, 60 durch ein Transportelement ersetzt sein. Das Transportelemenet kann eingerichtet sein, um das Behandlungsgut abzustützen und/oder zu transportieren. Das Transportelement kann beispielsweise als Walze oder als Rädchenachse ausgebildet sein.

Bei einem Ausführungsbeispiel kann eine der unterhalb der Transportebene vorgesehenen Anströmeinrichtungen 56, 60 so ausgebildet sein, dass der von der Anströmeinrichtung 56, 60 erzeugte Fluidstrom 33 eine Geschwindigkeitskomponente aufweist, die im Auslaufbereich 41 in Transportrichtung zeigt.

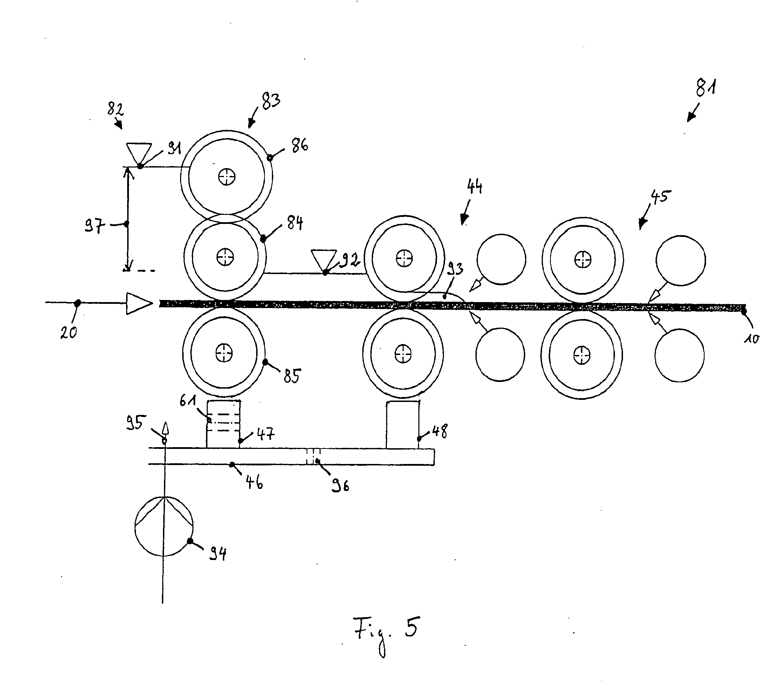

Fig. 5 ist eine schematische Seitenansicht eines Auslaufbereichs 81 einer Behandlungsstation. Ein derartiger Auslaufbereich 81 kann bei der Behandlungsstation 200 von Fig. 9 an einem Ende des Innenbehälters 201 vorgesehen werden, an dem das Behandlungsgut den Innenbehälter 201 verlässt. In dem Auslaufbereich wird ein Behandlungsgut 10 aus einem Behandlungsbereich 82, in dem eine Behandlungsflüssigkeit 21 so hoch angestaut ist, dass das Behandlungsgut eingetaucht ist, in einer Transportrichtung 20 weitertransportiert. Elemente oder Einrichtungen des Auslaufbereichs 81, die in ihrer Funktion und/oder Ausgestaltung Elementen oder Einrichtungen Auslaufbereichs 41 entsprechen, sind mit denselben Bezugszeichen versehen und werde nicht erneut eingehend erläutert.

In bestimmten Behandlungsstationen kann es wünschenswert sein, im Behandlungsbereich 82 ein relativ hohes Flüssigkeitsniveau 91 einzustellen. Das Flüssigkeitsniveau 91 in dem Behandlungsbereich 82 kann beispielsweise mindestens 15 mm über der Transportebene angeordnet sein.

Der Auslaufbereich 81 ist mit mehreren Vorrichtungen 83, 44 und 45 zum Entfernen oder Abhalten von Behandlungsflüssigkeit versehen. Die Vorrichtung 83 umfasst Walzen 84, 85, die so angeordnet sind, dass das Behandlungsgut 10 dazwischen durchgeführt werden kann. An wenigstens einer der Walzen 84, 85 der Vorrichtung 83 kann eine spaltbildende Rückhaltefläche zum Zurückhalten der Behandlungsflüssigkeit so ausgebildet sein, dass ein Spalt zwischen der Rückhaltefläche und der ihr gegenüberliegenden Oberfläche des Behandlungsgutes 10 ausgebildet wird, wenn das Behandlungsgut an den Walzen 84, 85 vorbeigeführt wird. Insbesondere kann wenigstens eine der Walzen 84, 85 erhöhte Randbereiche zum Transportieren des Behandlungsgutes 10 und eine dazwischen vorgesehene abgesetzte Rückhaltfläche aufweisen. Das Paar von Walzen 84, 85 kann beispielsweise wie die unter Bezugnahme auf Fig. 1 und 2 erläuterte Vorrichtung 1 ausgebildet sein.

Um ein Anstauen der Behandlungsflüssigkeit bis zu einem hohen Niveau 91 zu ermöglichen, weist die Vorrichtung 83 oberhalb der Walze 84 ein weiteres Rückhalteelement 86 auf. Das weitere Rückhalteelement 86 ist eingerichtet, um bei hohem Flüssigkeitsniveau in dem Behandlungsbereich 82 beim Anstauen der Behandlungsflüssigkeit mitzuwirken, indem es als Wand für die angestaute Flüssigkeit dient. Das weitere Rückhalteelement 86 kann beispielsweise als eine Walze ausgebildet sein, die komplementär zu der Walze 84 ausgebildet ist, so dass die Walzen 84, 86 dicht schließen und nur einen geringen oder gar keinen Durchtritt von Flüssigkeit zwischen den Walzen 84, 86 erlauben. Andere Ausgestaltungen für das weitere Element 86 sind möglich, beispielsweise in der Form einer Aufkantung.

Die Vorrichtung 83 ist so eingerichtet, dass ein Niveauunterschied 97 der Behandlungsflüssigkeit zwischen dem Niveau 91 in dem Behandlungsbereich 82 und einem Niveau 92 in dem dazu benachbarten Bereich an der anderen Seite der Vorrichtung 83 über die Vorrichtung 83 eingestellt und aufrechterhalten wird. Die in Transportrichtung der Vorrichtung 83 nachgeordnete Vorrichtung 44 entfernt weitere Behandlungsflüssigkeit von dem Behandlungsgut 10, wenn dieses die Vorrichtung 44 passiert. Anstelle des Niveaus 92 befindet sich an dem Behandlungsgut 10 nur noch eine kleinere Menge Behandlungsflüssigkeit 93, wenn das Behandlungsgut 10 das Walzenpaar der Vorrichtung 44 passiert hat. Die in Transportrichtung der Vorrichtung 44 nachgeordnete Vorrichtung 45 kann noch weitere Behandlungsflüssigkeit von dem Behandlungsgut 10 entfernen, sofern dies nach dem Durchlaufen der Vorrichtung 44 noch erforderlich ist.

Um den Niveauunterschied 97 einzustellen, sind in dem Wehr 47 verschließbare Öffnungen 61 vorgesehen. Das Niveau 92 in dem dem Behandlungsbereich 82 benachbarten Bereich wird bestimmt durch ein Gleichgewicht aus zu- und ablaufenden Strömen von Behandlungsflüssigkeit. Um diese und somit das Niveau 92 einstellen zu können, können in dem Boden 46 zwischen den Wehren 47, 48 eine oder mehrere Öffnungen 96, beispielsweise verschließbare Bohrungen, vorgesehen sein. Durch geeignete Wahl der in dem Wehr 47 geöffneten Öffnungen 61 und der in dem Boden 46 geöffneten Öffnungen 96 kann eine Grundeinstellung für ein gewünschtes Niveau 92 in dem dem Behandlungsbereich 82 benachbarten Bereich gewählt werden. Zusätzlich können an Elementen, die die Behandlungsstation seitlich begrenzen, beispielsweise an Lageraufnahmen, die für die Lagerung der Walzen der Vorrichtungen 83 und 44 vorgesehen sind, Überlaufwehre vorgesehen werden. Zusätzlich zulaufende Flüssigkeitsmengen können über die Überlaufwehre abgeführt werden.

Um den aus dem Behandlungsbereich 82 ablaufenden Strom von Behandlungsflüssigkeit auszugleichen, wird mit einer Pumpe 94 ein Strom 95 von Behandlungsflüssigkeit in den Behandlungsbereich 82 gefördert.

Während unter Bezugnahme auf Fig. 4 und 5 Ausgestaltungen von Auslaufbereichen einer Behandlungsstation beschrieben wurden, können Vorrichtungen zum Entfernen oder Abhalten von Behandlungsflüssigkeit entsprechend auch in einem Einlaufbereich einer Behandlungsstation vorgesehen werden. Insbesondere können auch in dem Einlaufbereich mehrere in Transportrichtung voneinander beabstandete Vorrichtungen zum Entfernen oder Abhalten von Behandlungsflüssigkeit vorgesehen werden, um zu verhindern, dass die Behandlungsflüssigkeit auf das Behandlungsgut strömt, bevor dieses in dem Einlaufbereich in die Behandlungsstation eingeführt wird.

Die Ausgestaltung der spaltbildenden Rückhaltefläche kann abhängig von dem spezifischen Anwendungsgebieten auf geeignete Weise gewählt werden.

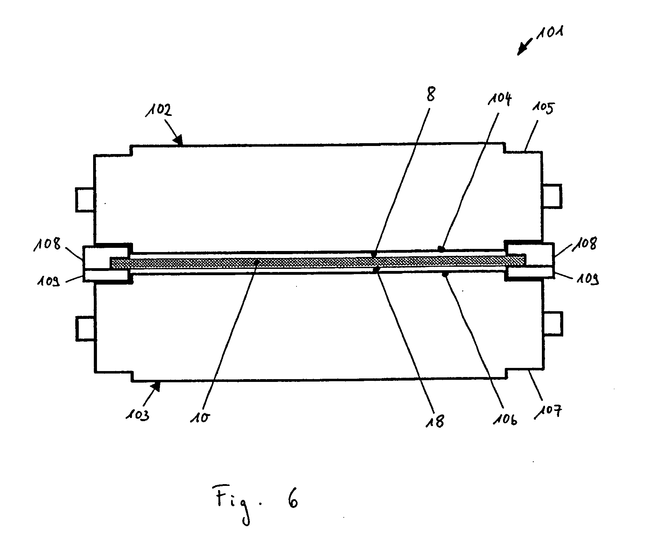

Fig. 6 ist eine schematische Vorderansicht einer Vorrichtung 101 zum Entfernen oder Abhalten von Behandlungsflüssigkeit nach einem weiteren Ausführungsbeispiel.

Die Vorrichtung 101 umfasst eine Walze 102 und eine weitere Walze 103. Die Walze 102 und die weitere Walze 103 sind so angeordnet, dass ein Behandlungsgut 10 zwischen den Walzen 102 und 103 hindurch transportiert werden kann. Eine Mantelfläche der Walze 102 weist eine Rückhaltefläche 104 auf, die zum Zurückhalten der Behandlungsflüssigkeit ausgebildet ist. Die Walze 102 mit der Rückhaltefläche 104 ist so ausgebildet, dass ein Spalt 8 zwischen der Rückhaltefläche 104 der Walze 102 und einer dieser gegenüberliegenden Oberfläche des Behandlungsgutes 10 freibleibt, wenn das Behandlungsgut 10 an der Walze 102 vorbeigeführt wird. Axiale Endabschnitte 105 der Walze 102 sind mit einem kleineren Durchmesser als der die Rückhaltefläche 104 definierende mittlere Abschnitt der Walze 102 ausgebildet, um als Transportabschnitte zum Transportieren des Behandlungsgutes 10 zu wirken, wenn dieses an seinen Längsrändern mit Halteschienen gehaltert ist.

Eine Mantelfläche der weiteren Walze 103 weist eine weitere Rückhaltefläche 106 auf, die zum Zurückhalten der Behandlungsflüssigkeit ausgebildet ist. Die weitere Walze 103 mit der weiteren Rückhaltefläche 106 ist so ausgebildet, dass ein Spalt 18 zwischen der weiteren Rückhaltefläche 106 der weiteren Walze 103 und einer dieser gegenüberliegenden Oberfläche des Behandlungsgutes 10 freibleibt, wenn das Behandlungsgut 10 an der weiteren Walze 103 vorbeigeführt wird. Axiale Endabschnitte 107 der weiteren Walze 103 sind mit einem kleineren Durchmesser als der die weitere Rückhaltefläche 106 definierende mittlere Abschnitt der weiteren Walze 103 ausgebildet, um als Transportabschnitte zum Transportieren des Behandlungsgutes 10 zu wirken, wenn dieses an seinen Längsrändern mit Halteschienen gehaltert ist.

An den Längsrändern des Behandlungsgutes 10 sind Halteschienen 108, 109 vorgesehen, die das Behandlungsgut zum Transportieren des Behandlungsgutes 10 haltern. Derartige Halteschienen 108, 109 können insbesondere beim Transportieren von Behandlungsgut mit geringer Eigensteifigkeit eingesetzt werden, um dem Behandlungsgut zusätzliche Stabilität zu verleihen. Die Walze 102 und weitere Walze 103 der Vorrichtung 101 sind so ausgestaltet, dass ihre axialen Endabschnitte 105, 107 mit kleinerem Durchmesser in Anlage mit den Halteschienen 108, 109 kommen. Durch Drehung der Walze 102 und der weiteren Walze 103 kann das Behandlungsgut 10 über die Halteschienen 108, 109 weitertransportiert werden.

Bei der Vorrichtung 101 sind die Rückhalteflächen 104, 106 der Walzen 102, 103 so gegenüber den am axialen Ende der Walzen 102, 103 vorgesehenen Transportabschnitt abgesetzt, dass Spalte 8, 18 mit gewünschter minimaler Spalthöhe zwischen den Rückhalteflächen 104, 106 und den ihnen gegenüberliegenden Oberflächen des Behandlungsgutes 10 ausgebildet werden, wenn das Behandlungsgut 10 an den Rückhalteflächen 104, 106 vorbeigeführt wird.

Bei der Vorrichtung 101 berühren die Walzen 102, 103 das Behandlungsgut 10 nicht unmittelbar. Der Transport des Behandlungsgutes 10 erfolgt über eine Kopplung der Transportabschnitte 105, 107 mit den Halteschienen 108, 109, an denen das Behandlungsgut 10 gehaltert ist.

Bei einer Abwandlung der Vorrichtung 101 können die Walzen 102, 103 so ausgebildet sein, dass sie das Behandlungsgut 10 in einem Randbereich neben den Halteschienen 108, 109 berühren, um es zu transportieren. Dazu können an den Walzen 102, 103 erhöhte Transportabschnitte vorgesehen sein, die das Behandlungsgut neben den Halteschienen 108, 109 berühren. Die Walzen 102, 103 können weiterhin so eingerichtet sein, dass auch zwischen den Walzen 102, 103 und den Halteschienen 108, 109 ein Spalt zum Verdrängen von Flüssigkeit ausgebildet wird. Dazu können relativ zu den Transportabschnitten der Walzen entsprechend zurückgesetzte Vertiefungen oder Nuten zum Abquetschen von Flüssigkeit von den Halteschienen an den Walzen 102, 103 vorgesehen werden. Der zwischen den Walzen und den Halteschienen ausgebildete Spalt kann eine minimale Spalthöhe aufweisen, die kleiner als 1 mm, insbesondere kleiner als 0,7 mm, insbesondere kleiner als 0,5 mm sein kann. Der zwischen den Walzen und den Halteschienen ausgebildete Spalt kann eine minimale Spalthöhe aufweisen, die mindestens 0,05 mm, insbesondere mindestens 0,07 mm, insbesondere mindestens 0,09 mm sein kann.

Die Vorrichtung 101 zum Abquetschen von Flüssigkeit von gehaltertem Behandlungsgut kann weiterhin auch eine Anströmeinrichtung umfassen. Die Anströmeinrichtung kann wie unter Bezugnahme auf Fig. 3 erläutert ausgebildet sein. Die Anströmeinrichtung kann insbesondere so ausgebildet sein, dass der von der Anströmeinrichtung ausgegebene Fluidstrom Behandlungsflüssigkeit auch von den Halteschienen entfernt.

In den Halteschienen 108, 109 können Durchlässe vorgesehen sein, die einen Durchtritt von Flüssigkeit durch die Halteschienen quer zur Transportrichtung ermöglichen.

Die Walzen 102, 103 können eingerichtet sein, um auf wenigstens an einem der Längsränder vorgesehene Halteschienen 108, 109 eine Kraft mit einer Kraftkomponente auszuüben, die in der Transportebene liegt und quer zur Transportrichtung gerichtet ist. Die Kraft kann so gerichtet sein, dass die an den gegenüberliegenden Längsrändern vorgesehene Halteschienen 108, 109 voneinander weg gedrückt werden, um das Behandlungsgut 10 quer zur Transportrichtung zu spannen. Dazu kann bzw. können beispielsweise die Halteschiene 108 und/oder 109 an wenigstens einem Längsrand des Behandlungsgutes einen oder mehrere Magneten, insbesondere Permanentmagneten, aufweisen. Die oberhalb der Transportebene vorgesehenen Walze 102 und/oder die unterhalb der Transportebene vorgesehene Walze 103 kann einen Magneten oder mehrere Magnete aufweisen, um auf die Halteschiene eine elektromagnetische Kraft auszuüben. Die Kraft kann so gerichtet sein, dass die Halteschienen an den gegenüberliegenden Längsrändern des Behandlungsgutes 10 federnd voneinander weg gedrückt werden.

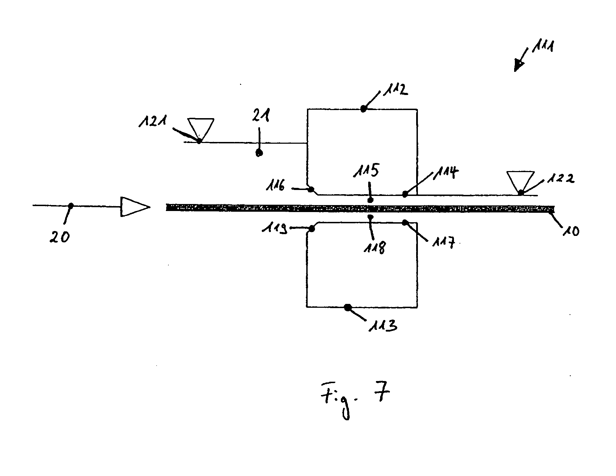

Fig. 7 ist eine schematische Seitenansicht einer Vorrichtung 111 zum Entfernen oder Abhalten von Behandlungsflüssigkeit nach einem weiteren Ausführungsbeispiel. Bei der Vorrichtung 111 sind die Rückhalteflächen nicht an einer drehbar gelagerten Walze vorgesehen.

Die Vorrichtung 111 umfasst zwei im Wesentlichen quaderförmige Elemente 112, 113, die als Einsätze in einer Anlage zur Behandlung eines Behandlungsgutes 10 verwendet werden können. Der Einsatz 112 ist oberhalb der Transportebene, und der Einsatz 113 ist unterhalb der Transportebene angeordnet. Eine Oberfläche der Einsätze 112, 113 dient als Rückhaltefläche, die Behandlungsflüssigkeit zurückhält.

Die Einsätze 112, 113 der Vorrichtung 111 sind relativ zu einem Transportweg des Behandlungsgutes 10 so angeordnet, dass zwischen einer der oberen Oberfläche des Behandlungsgutes 10 und einer dieser zugewandten Seitenfläche 114 des Einsatzes 112 ein Spalt 115 freibleibt, wenn das Behandlungsgut 10 an der Vorrichtung 111 vorbeigeführt wird, und dass zwischen unteren Oberfläche des Behandlungsgutes 10 und einer dieser zugewandten Seitenfläche 117 des Einsatzes 113 ein Spalt 118 freibleibt, wenn das Behandlungsgut 10 an der Vorrichtung 111 vorbeigeführt wird. Die Seitenfläche 114 des Einsatzes 112 und die Seitenfläche 117 des Einsatzes 117 können eine planare Ausgestaltung aufweisen, so dass die Spalte 115 und 118 sich entlang der Transportrichtung mit einer konstanten Spalthöhe erstrecken.

Die Einsätze 112, 113 der Vorrichtung 111 weisen einen sich gegen die Transportrichtung 20 öffnenden Einlaufbereich auf, der durch Abschrägungen 116, 119 an den Einsätzen 112, 113 ausgebildet wird. Ein derartiger Einlaufbereich kann beispielsweise zum Führen von Behandlungsgut mit geringer Eigensteifigkeit, beispielsweise von Folien, verwendet werden.

Die Vorrichtung 111 mit den Einsätzen 112, 113 kann zum Anstauen der Behandlungsflüssigkeit 21 in einer Anlage zur nasschemischen Behandlung des Behandlungsgutes 10 eingesetzt werden. Wenn das Behandlungsgut 10 von einem an einer ersten Seite (links in Fig. 7) der Einsätze angeordneten Behandlungsbereich, in dem die Behandlungsflüssigkeit 21 bis zu einem Niveau 121 angestaut ist, an den Einsätzen 112, 113 vorbeigeführt wird, verbleibt eine Schicht Behandlungsflüssigkeit mit einer geringeren Dicke 122 an dem Behandlungsgut 10.

Die Einsätze 112, 113 können je nach baulichen Gegebenheiten der Anlage, in denen die Vorrichtung 111 eingesetzt wird, geeignet konfiguriert werden. Beispielsweise können die Einsätze 112, 113 so ausgestaltet sein, dass die Spalte 115, 118 in der Transportrichtung 20 möglichst lang sind.

Die Einsätze 112, 113 können in der Anlage zur nasschemischen Behandlung drehfest montiert sein. Die Einsätze 112, 113 können in der Anlage insbesondere auch an einer in Transportrichtung festgelegten Position angebracht sein. Die Einsätze 112, 113 können so angebracht sein, dass sie vertikal gegeneinander beweglich sind.

Bei einer Abwandlung der Vorrichtung 111 ist oberhalb der Transportebene ein quaderförmiger Einsatz vorgesehen, während unterhalb der Transportebene eine Walze zum Transportieren des Behandlungsgutes vorgesehen ist. Der quaderförmige Einsatz kann beispielsweise dieselbe Ausgestaltung wie der Einsatz 112 der Vorrichtung 111 aufweisen.

Fig. 8 ist eine schematische Seitenansicht einer Behandlungsstation 131, in dem in einem Einlaufbereich ein Paar von Walzen 132, 133 und in einem Auslaufbereich ein weiteres Paar von Walzen 134, 135 vorgesehen ist. Die Walze 132 im Einlaufbereich ist oberhalb der Transportebene und die Walze 133 im Einlaufbereich ist unterhalb der Transportebene eines Behandlungsgutes 10 angeordnet. Die Walze 134 im Auslaufbereich ist oberhalb der Transportebene und die Walze 135 im Auslaufbereich ist unterhalb der Transportebene eines Behandlungsgutes 10 angeordnet. Mit den Walzenpaaren wird die Behandlungsflüssigkeit 21 in der Behandlungsstation 131 bis zu einem Niveau 136 angestaut.

Jede der Walzen 132-135 weist an ihren axialen Enden Transportabschnitte in der Form von Erhöhungen 5, 15 zum Transportieren des Behandlungsgutes auf. Zwischen den an den Enden vorgesehenen Transportabschnitten ist eine Rückhaltefläche 4, 14 mit kleinerem Durchmesser ausgebildet. Wie unter Bezugnahme auf Fig. 1 und 2 erläutert, bildet die Rückhaltefläche 4, 14 der Walzen einen Spalt mit dem an den Walzen vorbeigeführten Behandlungsgut aus, der sich in der Breitenrichtung des Behandlungsgutes erstreckt.

Die verschiedenen Abschnitte der Walze 132 im Einlaufbereich werden so drehend angetrieben, dass sich die Transportabschnitte 5 und die dazwischen angeordnete Rückhaltefläche 4 der oberhalb der Transportebene vorgesehenen Walze 132 gleichsinnig drehen. Die verschiedenen Abschnitte der Walze 133 im Einlaufbereich werden so drehend angetrieben, dass sich die Transportabschnitte 15 und die dazwischen angeordnete Rückhaltefläche 14 der unterhalb der Transportebene vorgesehenen Walze 133 gleichsinnig drehen. Die Drehrichtung 141 der Transportabschnitte 5 der oberhalb der Transportebene vorgesehenen Walze 132 ist so gewählt, dass sich die Transportabschnitte 5 an ihren Berührungspunkten mit dem Behandlungsgut 10 in der Transportrichtung 20 bewegen, um das Behandlungsgut 10 in der Transportrichtung 20 zu transportieren. Die Drehrichtung 143 der Transportabschnitte 15 der unterhalb der Transportebene vorgesehenen Walze 133 ist so gewählt, dass sich die Transportabschnitte 15 an ihren Berührungspunkten mit dem Behandlungsgut 10 in der Transportrichtung 20 bewegen, um das Behandlungsgut 10 in der Transportrichtung 20 zu transportieren. Die Rückhaltefläche 4 der oberhalb der Transportebene vorgesehenen Walze 132 wird gleichsinnig mit den Transportabschnitten 5 der Walze 132 in einer Drehrichtung 142 so gedreht, dass sich der Abschnitt der Rückhaltefläche 4, der gerade zu dem Behandlungsgut 10 zeigt, in Richtung des höheren Flüssigkeitsniveaus (in Fig. 8 nach rechts) bewegt. Ähnlich wird die Rückhaltefläche 14 der unterhalb der Transportebene vorgesehenen Walze 133 gleichsinnig mit den Transportabschnitten 15 in einer Drehrichtung 144 so gedreht, dass sich der Abschnitt der Rückhaltefläche 14, der gerade zu dem Behandlungsgut 10 zeigt, in Richtung des höheren Flüssigkeitsniveaus (in Fig. 8 nach rechts) bewegt.

Durch geeignete Ausgestaltung der Walzen 132, 133 kann ein ausreichend hohes Flüssigkeitsniveau 136 angestaut werden, während die Bewegung der Rückhalteflächen 4 gegen den Bereich mit dem hohen Flüssigkeitsniveau den Durchtritt von Flüssigkeit durch die an den Rückhalteflächen 4 der Walzen 132, 133 ausgebildete Spalte ausreichend verringert. Dazu können die Walzen 132, 133 so ausgestaltet sein, dass ein Spalt mit einer minimalen Spalthöhe von weniger als 0,3 mm, beispielsweise ca. 0,1 mm zwischen der Rückhaltefläche 4, 14 und der der Rückhaltefläche gegenüberliegenden Oberfläche des Behandlungsgutes 10 ausgebildet wird. Beispielsweise können die Transportabschnitte um weniger als 0,3 mm, beispielsweise um ca. 0,1 mm, relativ zu der Rückhaltefläche erhöht sein.

Im Auslaufbereich werden die Transportabschnitte 5, 15 der Walzen 134, 135 mit einer Drehrichtung 145, 147 so gedreht, dass sich die Transportabschnitte 5, 15 an ihren Berührungspunkten mit dem Behandlungsgut 10 in der Transportrichtung 20 bewegen.

Um mit den Walzen 134, 135 im Auslaufbereich den Durchtritt von Flüssigkeit durch die im Auslaufbereich gebildeten Spalte zu verringern, kann die oberhalb der Transportebene vorgesehene Walze 134 so ausgebildet sein, dass die Rückhaltefläche 4 der Walze 134 relativ zu dem Transportabschnitt 5 der Walze 134 drehbar ist. Ähnlich kann die unterhalb der Transportebene vorgesehene Walze 135 so ausgebildet sein, dass die Rückhaltefläche 14 der Walze 135 relativ zu dem Transportabschnitt 15 der Walze 135 drehbar ist. Im Auslaufbereich kann die Rückhaltefläche 4 der oberhalb der Transportebene vorgesehenen Walze 134 in einer Drehrichtung 146 gedreht werden, die gegensinnig zur Drehrichtung 145 des Transportabschnitts 5 dieser Walze 134 ist. Die Rückhaltefläche 14 der unterhalb der Transportebene vorgesehenen Walze 135 kann in einer Drehrichtung 148 gedreht werden, die gegensinnig zur Drehrichtung 147 des Transportabschnitts 15 dieser Walze 135 ist. Auf diese Weise kann auch im Auslaufbereich eine Drehung der Rückhalteflächen 4, 14 derart erfolgen, dass sich der Abschnitt der Rückhaltefläche 4 der oberhalb der Transportebene vorgesehenen Walze 134, der gerade zu dem Behandlungsgut 10 zeigt, in Richtung des höheren Flüssigkeitsniveaus (in Fig. 8 nach links) bewegt. Ähnlich kann die Rückhaltefläche 14 der Walze 135 gegensinnig zu dem Transportabschnitt 15 so gedreht werden, dass sich der Abschnitt der Rückhaltefläche 14 der Walze 135, der gerade zu dem Behandlungsgut 10 zeigt, in Richtung des höheren Flüssigkeitsniveaus (in Fig. 8 nach links) bewegt.

Auch die Walzen 134, 135 im Auslaufbereich können so ausgestaltet sein, dass ein Spalt mit einer minimalen Spalthöhe von weniger als 0,3 mm, beispielsweise ca. 0,1 mm zwischen der Rückhaltefläche 4, 14 und der der Rückhaltefläche gegenüberliegenden Oberfläche des Behandlungsgutes 10 ausgebildet wird. Beispielsweise können die Transportabschnitte um weniger als 0,3 mm, beispielsweise um ca. 0,1 mm, relativ zu der Rückhaltefläche erhöht sein.

Alternativ oder zusätzlich kann bzw. können im Einlaufbereich und/oder im Auslaufbereich der Behandlungsstation 131 jeweils eine oder mehrere Blaseinrichtungen vorgesehen sein, um durch die Spalte austretende Behandlungsflüssigkeit mit einem Fluidstrom zu entfernen, wie unter Bezugnahme auf Fig. 3 erläutert.

Durch geeignete Ausgestaltung der Walzenpaare im Einlaufbereich und/oder Auslaufbereich ist es möglich, einen Austritt von Flüssigkeit durch die Spalte, die beim Transportieren des Behandlungsgutes freibleiben, so zu verringern, dass im Einlaufbereich und/oder im Auslaufbereich der Behandlungsstation keine Anströmeinrichtung zum Abblasen von Behandlungsflüssigkeit vorgesehen wird.

Im Einlaufbereich und/oder im Auslaufbereich können auch jeweils mehrere Vorrichtungen zum Entfernen oder Abhalten von Behandlungsflüssigkeit vorgesehen sein, wie unter Bezugnahme auf Fig. 4 und 5 erläutert.

Die Vorrichtungen und Verfahren nach verschiedenen Ausführungsbeispielen erlauben es, in einer Anlage zur nasschemischen Behandlung von Behandlungsgut eine Behandlungsflüssigkeit von dem Behandlungsgut zu entfernen oder abzuhalten, wobei ein direkter Kontakt zwischen Abquetschwalzen und einem Nutzbereich des Behandlungsgutes verringert oder vermieden werden kann.

Zahlreiche Abwandlungen der in den Figuren dargestellten und detailliert beschriebenen Ausführungsbeispiele können bei anderen Ausführungsbeispielen realisiert werden.

Während bei verschiedenen Ausführungsbeispielen Rückhalteflächen beschrieben wurden, die sich in Breitenrichtung des Behandlungsgutes im Wesentlichen in gleicher Höhe quer zum Behandlungsgut erstrecken, kann die spaltbildende Rückhaltefläche auch so ausgebildet sein, dass sich der Querschnitt des Spaltes, insbesondere die Spalthöhe, in der Breitenrichtung des Behandlungsgutes verändert. Beispielsweise kann die Rückhaltefläche in Breitenrichtung des Behandlungsgutes konkav sein, so dass der ausgebildete Spalt, als Funktion einer Position in Breitenrichtung des Behandlungsgutes, in der Mitte des Behandlungsgutes höher als an den Rändern ist.

Während die verschiedenen Ausführungsbeispiele insbesondere bei Behandlungsanlagen eingesetzt werden können, in denen das Behandlungsgut kontinuierlich und in einer horizontalen Transportebene transportiert wird, können Ausführungsbeispiele auch bei Anlagen eingesetzt werden, in denen das Behandlungsgut in einer vertikalen Transportebene transportiert wird. Beispielsweise kann eine Kombination aus spaltbildender Rückhaltefläche und Anströmeinrichtung auch zum Anstauen von Flüssigkeit verwendet werden, wenn das Behandlungsgut in einer vertikalen Transportebene transportiert wird.

Während im Kontext von Ausführungsbeispielen die Verwendung von Vorrichtungen zum Entfernen oder Abhalten von Behandlungsflüssigkeit in einem Einlaufbereich und/oder in einem Auslaufbereich einer Behandlungsstation beschrieben wurde, kann eine derartige Vorrichtung auch innerhalb einer Behandlungseinheit eingesetzt werden, um Flüssigkeit zu verdrängen, beispielsweise für einen verbesserten Stoffaustausch.

Die Vorrichtungen und Verfahren nach den verschiedenen Ausführungsbeispielen können beispielsweise bei der Herstellung von Leiterplatten, wie gedruckten Leiterplatten, eingesetzt werden, ohne dass ihre Anwendung darauf beschränkt ist.

### BEZUGSZEICHENLISTE

- 1: Vorrichtung zum Entfernen von Behandlungsflüssigkeit
- 2: Walze
- 3: weitere Walze
- 4: Rückhaltefläche
- 5, 6: erhöhter Randabschnitt
- 7: Welle
- 8: Spalt
- 9: minimale Spalthöhe
- 10: Behandlungsgut
- 11: Nutzbereich
- 12: Randbereich
- 14: weitere Rückhaltefläche
- 15, 16: erhöhter Randabschnitt
- 17: Welle
- 18: weiterer Spalt
- 19: minimale Spalthöhe
- 20: Transportrichtung
- 21: Behandlungsflüssigkeit
- 22: Flüssigkeitsniveau
- 23: Behandlungsflüssigkeit
- 24: Flüssigkeitsniveau
- 25, 26: Drehrichtung
- 31: Vorrichtung zum Entfernen von Behandlungsflüssigkeit
- 32: Anströmeinrichtung
- 33: Fluidstrom
- 34: Behandlungsflüssigkeit
- 41: Auslaufbereich
- 42: Behandlungsbereich
- 43, 44, 45: Vorrichtung zum Entfernen von Behandlungsflüssigkeit
- 46: Boden
- 47, 48: Wehr
- 51, 52: Walze
- 53, 55: Walze
- 54, 56: Anströmeinrichtung
- 57, 59: Walze
- 58, 60: Anströmeinrichtung
- 61: Öffnung
- 71, 72: Flüssigkeitsniveau
- 73: Behandlungsflüssigkeit
- 74: Niveauunterschied
- 81: Auslaufbereich
- 82: Behandlungsbereich
- 83: Vorrichtung zum Entfernen von Behandlungsflüssigkeit
- 84-86: Walze
- 91, 92: Flüssigkeitsniveau
- 93: Behandlungsflüssigkeit
- 94: Pumpe
- 95: Flüssigkeitsstrom
- 96: Öffnung
- 97: Niveauunterschied
- 101: Vorrichtung zum Entfernen von Behandlungsflüssigkeit
- 102: Walze
- 103: weitere Walze
- 104: Rückhaltefläche
- 105: zurückgesetzter Randabschnitt
- 106: weitere Rückhaltefläche
- 107: zurückgesetzter Randabschnitt
- 108, 109: Halteschiene
- 111: Vorrichtung zum Entfernen von Behandlungsflüssigkeit
- 112, 113: Einsatz
- 114, 117: Seitenfläche
- 115, 118: Spalt
- 116, 119: Abschrägung
- 131: Behandlungsstation
- 132-135: Walze
- 136: Flüssigkeitsniveau
- 141-148: Drehrichtung
- 200: Behandlungsstation
- 201: Innenbehälter
- 202: Außenbehälter
- 203: Behandlungsgut
- 204: Transportrichtung
- 206, 207: Anströmdüse
- 208: Behandlungsflüssigkeit
- 209: Niveau im Außenbehälter
- 210: Pumpe
- 211, 212, 214, 216: Transportwalzenpaar
- 213, 215: Abquetschwalzenpaar

## Patentansprüche

1. Verfahren zum Behandeln eines flächigen Behandlungsgutes (10), das in einer Anlage zur nasschemischen Behandlung des Behandlungsgutes (10) entlang einem Transportweg transportiert wird,
wobei das Behandlungsgut (10) in der Anlage einer Behandlungsflüssigkeit (21) ausgesetzt wird, und
wobei eine Rückhaltefläche (4, 14) zum Zurückhalten der Behandlungsflüssigkeit (21) derart an dem Transportweg positioniert wird, dass zwischen der Rückhaltefläche (4, 14) und einer Oberfläche des Behandlungsgutes (10) ein Spalt (8, 18) freibleibt, wenn das Behandlungsgut (10) an der Rückhaltefläche (4, 14) vorbeigeführt wird,
wobei die Rückhaltefläche (4, 14) an einer Walze (51, 52; 84, 85) ausgebildet ist, **dadurch gekennzeichnet,**
**dass** die Walze (51, 52; 84, 85) so in Drehung versetzt wird, dass sich ein Teil der Walzenoberfläche, der den Spalt (8, 18) an einer Seite begrenzt, in einer Richtung bewegt, die entgegengesetzt zu einer Transportrichtung des Behandlungsgutes (10) ist.

2. Verfahren nach Anspruch 1,
wobei eine durch den Spalt (8, 18) tretende Behandlungsflüssigkeit (21) von dem Behandlungsgut (10) mit einem das Behandlungsgut (10) anströmenden Fluidstrom entfernt wird.

3. Verfahren nach Anspruch 2,
wobei ein zum Entfernen der Behandlungsflüssigkeit (21) verwendeter Fluidstrom (33) so eingerichtet ist, dass er nicht durch den Spalt (8, 18) tritt.

4. Verfahren nach einem der vorhergehenden Ansprüche,
wobei ein Niveauunterschied (74; 97) der Behandlungsflüssigkeit (21) an entgegengesetzten Seiten des Spaltes (8, 18) eingestellt wird.

5. Verfahren nach einem der vorhergehenden Ansprüche,
wobei die Rückhaltefläche (4, 14) so gedreht wird, dass ein Durchtritt von Behandlungsflüssigkeit (21) durch den Spalt (8, 18) verringert oder unterbunden wird.

6. Verfahren nach einem der vorhergehenden Ansprüche,
wobei die Behandlungsflüssigkeit (21) mit der Rückhaltefläche (4, 14) in einer Behandlungsstation so angestaut wird, dass das Behandlungsgut (10) in der Behandlungsstation in die Behandlungsflüssigkeit (21) eingetaucht transportiert wird.

7. Vorrichtung zum Entfernen oder Abhalten von Behandlungsflüssigkeit (21) von einem flächigen Behandlungsgut (10) für eine Anlage zur nasschemischen Behandlung des Behandlungsgutes (10),
wobei die Vorrichtung eine Rückhaltefläche (4, 14) zum Zurückhalten der Behandlungsflüssigkeit (21) umfasst und eingerichtet ist, um relativ zu einem Transportweg des Behandlungsgutes (10) so angeordnet zu werden, dass die Vorrichtung einen Spalt (8, 18) zwischen der Rückhaltefläche (4, 14) und einer Oberfläche des entlang dem Transportweg transportierten Behandlungsgutes (10) ausbildet, wobei die Rückhaltefläche (4, 14) an einer Walze (51, 52; 84, 85) ausgebildet ist,
**dadurch gekennzeichnet,**
**dass** die Vorrichtung eine Antriebseinrichtung umfasst, die eingerichtet ist, um die Walze (51, 52; 84, 85) so in Drehung zu versetzen, dass sich ein Teil der Walzenoberfläche, der den Spalt (8, 18) an einer Seite begrenzt, in einer Richtung bewegt, die entgegengesetzt zu einer Transportrichtung des Behandlungsgutes (10) ist.

8. Vorrichtung nach Anspruch 7,
wobei die Behandlungsflüssigkeit an beiden Seiten der Walze (51; 84) angestaut wird, und wobei ein Niveauunterschied (74; 97) der Behandlungsflüssigkeit (21) an entgegengesetzten Seiten des Spaltes (8, 18) eingestellt wird.

9. Vorrichtung nach Anspruch 7 oder 8, umfassend
eine von der Rückhaltefläche (4, 14) beabstandete Anströmeinrichtung (32; 54, 56, 58, 60), die eingerichtet ist, um mit einem Fluidstrom (33) die Behandlungsflüssigkeit (21) von dem Behandlungsgut (10) zu entfernen.

10. Vorrichtung nach Anspruch 9,
wobei die Anströmeinrichtung (32; 54, 56, 58, 60) derart eingerichtet und angeordnet ist, dass der Fluidstrom (33) nicht durch den Spalt (8, 18) hindurchtritt.

11. Vorrichtung nach einem der Ansprüche 7-10,
die zur Verwendung in dem Verfahren nach einem der Ansprüche 1-6 eingerichtet ist.

12. Anlage zum Behandeln eines flächigen Behandlungsgutes (10), wobei die Anlage eingerichtet ist, um auf wenigstens eine Oberfläche des Behandlungsgutes (10) eine Behandlungsflüssigkeit (21) aufzubringen oder das Behandlungsgut (10) in eine Behandlungsflüssigkeit (21) zu tauchen, und wobei die Anlage eingerichtet ist, um das Behandlungsgut entlang einem Transportweg zu transportieren,
umfassend
eine Vorrichtung (1; 31; 43, 44, 45; 83; 101; 111) nach einem der Ansprüche 7-11 zum Entfernen oder Abhalten der Behandlungsflüssigkeit (21) von dem Behandlungsgut (10).

13. Anlage nach Anspruch 12,
umfassend eine Behandlungsstation, in welcher die Behandlungsflüssigkeit (21) anstaubar ist, wobei die Vorrichtung (134, 135) nach einem der Ansprüche 7-11 in einem Auslaufbereich der Behandlungsstation vorgesehen ist, und
wobei eine weitere Vorrichtung zum Entfernen oder Abhalten von Behandlungsflüssigkeit (21) in einem Einlaufbereich der Behandlungsstation vorgesehen ist, wobei die im Einlaufbereich vorgesehene Vorrichtung eine Rückhaltefläche (4, 14) zum Zurückhalten der Behandlungsflüssigkeit (21) umfasst und relativ zu dem Transportweg des Behandlungsgutes (10) so angeordnet ist, dass die Vorrichtung einen Spalt (8, 18) zwischen der Rückhaltefläche (4, 14) und einer Oberfläche des entlang dem Transportweg transportierten Behandlungsgutes (10) ausbildet,
wobei die Anlage eingerichtet ist, um die Rückhaltefläche (4) der in dem Einlaufbereich der Behandlungsstation vorgesehenen Vorrichtung (132, 133) und die Rückhaltefläche (4) der in dem Auslaufbereich der Behandlungsstation vorgesehenen Vorrichtung (134, 135) gegensinnig zu drehen.

14. Verfahren zum Herstellen einer Leiterplatten,
wobei die Leiterplatte aus einem mit dem Verfahren nach einem der Ansprüche 1-6 behandelten Behandlungsgut hergestellt wird.

## Claims

1. Method for treating a planar material to be treated (10), which is transported in an assembly for wet-chemical treatment of the material to be treated (10) along a transport path,
the material to be treated (10) being subjected to a treatment liquid (21) in the assembly, and
a retaining surface (4, 14) for holding back the treatment liquid (21) being positioned on the transport path so that a gap (8, 18) remains between the retaining surface (4, 14) and a surface of the material to be treated (10), when the material to be treated (10) is moved past the retaining surface (4, 14),
the retaining surface (4, 14) being formed on a roll (51, 52; 84, 85),
**characterized in that**
the roll (51, 52; 84, 85) is set in rotation so that a part of the roll surface which delimits the gap (8, 18) on one side moves in a direction which is opposite to the transport direction of the material to be treated (10).

2. Method according to claim 1,
wherein a treatment liquid (21) passing through the gap (8, 18) is removed from the material to be treated (10) by a fluid flow flowing onto the material to be treated (10).

3. Method according to claim 2,
wherein a fluid flow (33) used for removing the treatment liquid (21) is directed so that it does not pass through the gap (8, 18).

4. Method according to any one of the preceding claims,
wherein a difference in levels (74; 97) of the treatment liquid (21) is set on opposing sides of the gap (8, 18).

5. Method according to any one of the preceding claims,
wherein the retaining surface (4, 14) is rotated so that a passage of treatment liquid (21) through the gap (8, 18) is reduced or prevented.

6. Method according to any one of the preceding claims,
wherein the treatment liquid (21) is accumulated by the retaining surface (4, 14) in a treatment station so that the material to be treated (10) is transported in the treatment station while being immersed in the treatment liquid (21).

7. Device for removing or holding off treatment liquid (21) from a planar material to be treated (10) for an assembly for wet-chemical treatment of the material to be treated (10),
the device comprising a retaining surface (4, 14) for holding back the treatment liquid (21) and being configured to be arranged relative to a transport path of the material to be treated (10) so that the device forms a gap (8, 18) between the retaining surface (4, 14) and a surface of the material to be treated (10) transported along the transport path, the retaining surface (4, 14) being formed on a roll (51, 52; 84, 85),
**characterized in that**
the device comprises a drive device which is configured to set the roll (51, 52; 84, 85) in rotation so that a part of the roll surface which delimits the gap (8, 18) on one side moves in a direction opposite to the transport direction of the material to be treated (10).

8. Device according to claim 7,
wherein the treatment liquid is accumulated on both sides of the roll (51; 84), and a difference in levels (74; 97) of the treatment liquid (21) is set on opposing sides of the gap (8, 18).

9. Device according to claim 7 or claim 8, comprising a flow device (32; 54, 56, 58, 60) spaced apart from the retaining surface (4, 14) which is configured to remove, by means of a fluid flow (33), the treatment liquid (21) from the material to be treated (10).

10. Device according to claim 9,
wherein the flow device (32; 54, 56, 58, 60) is configured and arranged such that the fluid flow (33) does not pass through the gap (8, 18).

11. Device according to any one of claims 7-10, which is configured for use in the method according to any one of Claims 1-6.

12. Assembly for treating a planar material to be treated (10), the assembly being configured to apply on at least one surface of the material to be treated (10) a treatment liquid (21) or to immerse the material to be treated (10) in a treatment liquid (21), and the assembly being configured to transport the material to be treated along a transport path,
comprising
a device (1; 31; 43, 44, 45; 83; 101; 111) according to any one of claims 7-11 for removing or holding off the treatment liquid (21) from the material to be treated (10).

13. Assembly according to Claim 12,
comprising a treatment station, which is configured to accumulate the treatment liquid (21), wherein the device (134, 135) according to any one of claims 7-11 is provided in an outflow region of the treatment station, and
wherein a further device for removing or holding off treatment liquid (21) is provided in an inflow region of the treatment station, wherein the device provided in the inflow region comprises a retaining surface (4, 14) for holding back the treatment liquid (21) and is arranged relative to the transport path of the material to be treated (10) so that the device forms a gap (8, 18) between the retaining surface (4, 14) and a surface of the material to be treated (10) transported along the transport path,
wherein the assembly is configured to rotate in opposite directions the retaining surface (4) of the device (132, 133) provided in the inflow region of the treatment station and the retaining surface (4) of the device (134, 135) provided in the outflow region of the treatment station.

14. Method for producing a circuit board, the circuit board being produced from a material to be treated, which is treated using the method according to any one of claims 1-6.

## Revendications

1. Procédé servant à traiter un produit à traiter (10) plat, qui est transporté le long d'une voie de transport dans une installation servant au traitement par voie chimique humide du produit à traiter (10),
sachant que le produit à traiter (10) est exposé dans l'installation à un liquide de traitement (21), et
sachant qu'une face de retenue (4, 14) servant à retenir le liquide de traitement (21) est positionnée au niveau de la voie de transport de telle manière qu'un interstice (8, 18) reste dégagé entre la face de retenue (4, 14) et une surface du produit à traiter (10) lorsque le produit à traiter (10) est guidé le long de la face de retenue (4, 14),
sachant que la face de retenue (4, 14) est réalisée au niveau d'un cylindre (51, 52 ; 84, 85),
**caractérisé en ce**
**que** le cylindre (51, 52 ; 84, 85) est amené en rotation de telle manière qu'une partie de la surface de cylindre, qui délimite au niveau d'un côté l'interstice (8, 18), se déplace dans une direction, qui est opposée à une direction de transport du produit à traiter (10).

2. Procédé selon la revendication 1,
sachant qu'un liquide de traitement (21) traversant l'interstice (8, 18) est éliminé du produit à traiter (10) à l'aide d'un flux de fluide affluant vers le produit à traiter (10).

3. Procédé selon la revendication 2,
sachant qu'un flux de fluide (33) utilisé pour éliminer le liquide de traitement (21) est mis au point de telle manière qu'il ne traverse pas l'interstice (8, 18).

4. Procédé selon l'une quelconque des revendications précédentes,
sachant qu'une différence de niveau (74 ; 97) du liquide de traitement (21) est ajustée au niveau de côtés opposés de l'interstice (8, 18).

5. Procédé selon l'une quelconque des revendications précédentes,
sachant que la face de retenue (4, 14) est tournée de telle manière qu'un passage de liquide de traitement (21) à travers l'interstice (8, 18) est réduit ou empêché.

6. Procédé selon l'une quelconque des revendications précédentes,
sachant que le liquide de traitement (21) est accumulé dans un poste de traitement à l'aide de la face de retenue (4, 14) de telle manière que le produit à traiter (10) est transporté dans le poste de traitement en étant plongé dans le liquide de traitement (21).

7. Dispositif servant à éliminer ou à retenir du liquide de traitement (21) d'un produit à traiter (10) plat, destiné à une installation servant au traitement par voie chimique humide du produit à traiter (10),
sachant que le dispositif comprend une face de retenue (4, 14) servant à retenir le liquide de traitement (21) et est mis au point pour être disposé par rapport à une voie de transport du produit à traiter (10) de telle manière que le dispositif forme un interstice (8, 18) entre la face de retenue (4, 14) et une surface du produit à traiter (10) transporté le long de la voie de transport, sachant que la face de retenue (4, 14) est réalisée au niveau d'un cylindre (51, 52 ; 84, 85),
**caractérisé en ce**
**que** le dispositif comprend un système d'entraînement, qui est mis au point pour amener le cylindre (51, 52 ; 84, 85) en rotation de telle manière qu'une partie de la surface de cylindre, laquelle délimite au niveau d'un côté l'interstice (8, 18), se déplace dans une direction qui est opposée à une direction de transport du produit à traiter (10).

8. Dispositif selon la revendication 7,
sachant que le liquide de traitement est accumulé au niveau des deux côtés du cylindre (51 ; 84), et
sachant qu'une différence de niveau (74 ; 97) du liquide de traitement (21) est ajustée au niveau de côtés opposés de l'interstice (8, 18).

9. Dispositif selon la revendication 7 ou 8, comprenant
un système d'admission de flux (32 ; 54, 56, 58, 60) tenu à distance de la face de retenue (4, 14), qui est mis au point pour éliminer du produit à traiter (10), à l'aide d'un flux de fluide (33), le liquide de traitement (21).

10. Dispositif selon la revendication 9,
sachant que le système d'admission de flux (32 ; 54, 56, 58, 60) est mis au point et est disposé de telle manière que le flux de fluide (33) ne traverse pas l'interstice (8, 18).

11. Dispositif selon l'une quelconque des revendications 7 à 10,
qui est mis au point aux fins de l'utilisation dans le procédé selon l'une quelconque des revendications 1 à 6.

12. Installation servant à traiter un produit à traiter (10) plat, sachant que l'installation est mise au point pour appliquer un liquide de traitement (21) sur au moins une surface du produit à traiter (10) ou pour plonger le produit à traiter (10) dans un liquide de traitement (21), et sachant que l'installation est mise au point pour transporter le produit à traiter le long d'une voie de transport,
comprenant
un dispositif (1 ; 31 ; 43, 44, 45 ; 83 ; 101 ; 111) selon l'une quelconque des revendications 7 à 11 servant à éliminer ou à retenir le liquide de traitement (21) du produit à traiter (10).

13. Installation selon la revendication 12,
comprenant un poste de traitement, dans lequel le liquide de traitement (21) peut être accumulé, sachant que le dispositif (134, 135) selon l'une quelconque des revendications 7 à 11 est prévu dans une zone d'évacuation du poste de traitement, et
sachant qu'un autre dispositif servant à éliminer ou à retenir le liquide de traitement (21) est prévu dans une zone d'arrivée du poste de traitement, sachant que le dispositif prévu dans la zone d'arrivée comprend une face de retenue (4, 14) servant à retenir le liquide de traitement (21) et est disposé par rapport à la voie de transport du produit à traiter (10) de telle manière que le dispositif forme un interstice (8, 18) entre la face de retenue (4, 14) et une surface du produit à traiter (10) transporté le long de la voie de transport,
sachant que l'installation est mise au point pour faire tourner en sens contraire la face de retenue (4) du dispositif (132, 133) prévu dans la zone d'arrivée du poste de traitement et la face de retenue (4) du dispositif (134, 135) prévu dans la zone d'évacuation du poste de traitement.

14. Procédé servant à fabriquer une carte de circuits imprimés,
sachant que la carte de circuits imprimés est fabriquée à partir d'un produit à traiter traité à l'aide d'un procédé selon l'une quelconque des revendications 1 à 6.
